(19) Europäisches Patentamt
European Patent Office
Office européen des brevets

(11) EP 2 367 056 A2

(12) EUROPEAN PATENT APPLICATION

(43) Date of publication:
**21.09.2011 Bulletin 2011/38**

(51) Int Cl.:
***G03F 7/027*** *(2006.01)*

(21) Application number: **11158236.7**

(22) Date of filing: **15.03.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.03.2010 JP 2010058390**

(71) Applicant: **Fujifilm Corporation**
**Minato-ku**
**Tokyo 106-0031 (JP)**

(72) Inventor: **Taguchi, Yoshinori**
**Shizuoka (JP)**

(74) Representative: **HOFFMANN EITLE**
**Patent- und Rechtsanwälte**
**Arabellastraße 4**
**81925 München (DE)**

# (54) Method of preparing lithographic printing plate

(57) To provide a method of preparing a lithographic printing plate which is excellent not only in developing property, sensitivity and ink-receptive property but also in printing durability and reproducibility of halftone dot and inhibits the generation of development scum in a developer to be excellent in processing property, in spite of conducting the development using a developer having pH from 2 to 11, a method of preparing a lithographic printing plate comprising (A) an exposure step of exposing imagewise a lithographic printing plate precursor comprising a hydrophilic support, a photosensitive layer containing (i) a binder polymer, (ii) an ethylenically unsaturated compound having a hydrophilic group selected from the group consisting of at least one of an acid group and a salt thereof, an onium salt and a polyalkyleneoxy group and (iii) a polymerization initiator and a protective layer in this order, and (B) a development step of removing an unexposed area of the photosensitive layer and the protective layer of the lithographic printing plate precursor with a one bath using a developer having pH from 2 to 11 is provided.

EP 2 367 056 A2

## Description

### FIELD OF THE INVENTION

The present invention relates to a method of preparing a lithographic printing plate.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

In recent years, digitalized technique of electronically processing, accumulating and outputting image information using a computer has been popularized, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

Further, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous alkali solution having pH of more than 11, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, a developing method of processing with a developer having pH from 8.5 to 11.5 and a dielectric constant from 3 to 30 mS/cm and containing an alkali metal carbonate and an alkali metal hydrogen carbonate is proposed in JP-A-11-65126 (the term "JP-A" as used herein means an "unexamined published Japanese patent application"). However, since the developing method is required a water-washing step and a treatment step with a gum solution, it does not resolve the problems of the environment and running cost.

Further, the lithographic printing plate precursor as described in JP-A-11-65126 has problems in that when a large amount of the lithographic printing plate precursors is subjected to development processing with a developer having a reduced pH, scum derived from an ethylenically unsaturated compound is apt to occur in the developer and in that when printing is conducted by a printing machine after exposure and development processing, a halftone, dot area (small halftone dot area) is reduced.

A method of preparing a lithographic printing plat including processing with a developer having pH from 11.9 to 12.1 and containing a water-soluble polymer compound is described in EP-A-1868036. However, since the lithographic printing plate obtained by the processing is left in the state that the alkali of pH 12 adheres on the surface thereof, a problem in view of safety of an operator arises and also another problem occurs in that with the lapse of long time after the preparation of the lithographic printing plate until the initiation of printing, the image area gradually dissolves to result

in deterioration in printing durability or ink-receptive property.

On the other hand, a method of preparing a lithographic printing plate where a water washing step is not conducted and development processing is conducted using a developer other than that of strong alkaline to remove a protective layer and the unexposed area of a photosensitive layer by one developing tank (one bath) is described in JP-T-2007-538279 (the term "JP-T" as used herein means a published Japanese translation of a PCT patent application). However, since the development is conducted at a weak alkaline in the method and solubility of a polymerizable compound or a binder is insufficient in the developer, development scum may occur sometimes when the development is continuously conducted.

## SUMMARY OF THE INVENTION

The present invention has been mage in view of the problems described above, and an object of the invention is to provide a method of preparing a lithographic printing plate which is excellent not only in developing property, sensitivity and ink-receptive property but also in printing durability and reproducibility of halftone dot and inhibits the generation of development scum in a developer to be excellent in processing property, in spite of conducting the development using a developer having pH from 2 to 11.

[1] A method of preparing a lithographic printing plate comprising (A) an exposure step of exposing imagewise a lithographic printing plate precursor comprising a hydrophilic support, a photosensitive layer containing (i) a binder polymer, (ii) an ethylenically unsaturated compound having a hydrophilic group selected from the group consisting of at least one of an acid group and a salt thereof, an onium salt and a polyalkyleneoxy group and (iii) a polymerization initiator and a protective layer in this order, and (B) a development step of removing an unexposed area of the photosensitive layer and the protective layer of the lithographic printing plate precursor with a one bath using a developer having pH from 2 to 11.

[2] The method of preparing a lithographic printing plate as described in the [1], wherein a log P value of the ethylenically unsaturated compound (ii) is from -1.00 to 3.50.

[3] The method of preparing a lithographic printing plate as described in the [1] or the [2], wherein the ethylenically unsaturated compound (ii) is a compound having a group represented by any of formulae shown below:

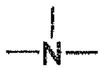
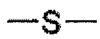

[4] The method of preparing a lithographic printing plate as described in any one of the [1] to the [3], wherein the ethylenically unsaturated compound (ii) is a compound having a group represented by any of formulae shown below:

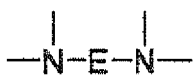
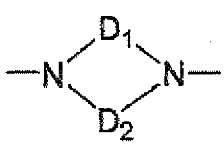
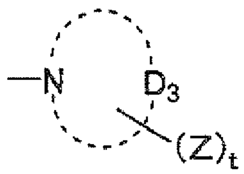

in formulae above, E represents (a) a divalent saturated hydrocarbon group, (b) an alicyclic group which may contain up to two atoms selected from the group consisting of a nitrogen atom, an oxygen atom and a sulfur atom in ring-forming atoms, (c) an arylene group or (d) a heterocyclic aromatic group, $D_1$ and $D_2$ each independently represents a saturated hydrocarbon group, $D_3$ represents a group which forms the ring together with the nitrogen atom and is composed of atoms selected from the group consisting of a carbon atom, an oxygen atom, a hydrogen atom, a nitrogen atom and a sulfur atom, t represents an integer from 1 to 10, and Z represents a hydrogen atom, a saturated hydrocarbon group or a group represented by a formula shown below:

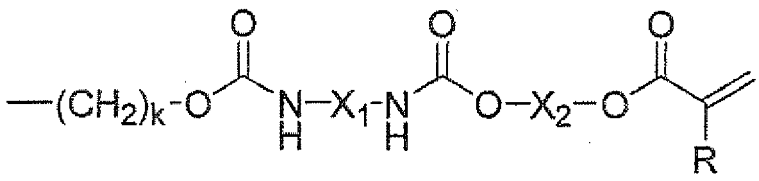

in formula above, $X_1$ represents a saturated hydrocarbon group or an aromatic hydrocarbon group, $X_2$ represents a saturated hydrocarbon group, an aromatic hydrocarbon group or a group represented by $-CH_2(O-Alk)_n-$, Alk represents an alkylene structure, n represents an integer from 1 to 50, R represents a hydrogen atom or a methyl group, and k represents an integer from 1 to 10.

[5] The method of preparing a lithographic printing plate as described in any one of the [1] to the [4], wherein the ethylenically unsaturated compound (ii) has at least one group selected from the group consisting of a urethane group, a urea group and a thiourethane group.

[6] The method of preparing a lithographic printing plate as described in any one of the [1] to the [5], wherein the ethylenically unsaturated compound (ii) is an oligomer having a weight average molecular weight from 1,000 to 10,000.

[7] The method of preparing a lithographic printing plate as described in the [1], wherein the ethylenically unsaturated compound (ii) is a compound represented by formula (I) shown below:

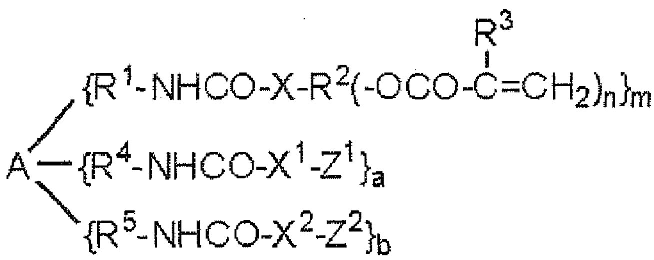

(I)

in formula (I), A represents a group a) or b) shown below:

a) a 2- to 6-valent hydrocarbon residue which may contain one or more ether bonds, ester bonds and amido bonds;
b) a 2- or 3-valent urea residue;

X, $X^1$ and $X^2$ each independently represents -O- or NR-, R represents an alkyl group, $R^1$, $R^4$ and $R^5$ each independently represents a divalent hydrocarbon residue, $R^2$ represents a 2- to 6-divalent straight chain or branched hydrocarbon residue, $R^3$ represents a hydrogen atom or a methyl group, $Z^1$ represents a hydrophilic group selected from the group consisting of at least one of an acid group and a salt thereof, an onium salt and a polyalkyleneoxy group, $Z^2$ represents a hydrophobic group selected from the group consisting of an alkyl group, a cycloalkyl group, an arylalkyl group, an alkylaryl group, an aryl group, an alkoxy group, a fluoroalkyl group or a perfluoroalkyl group and a silicone group, n, m and a each independently represents an integer from 1 to 5, and b represents an integer from 0 to 5, provided that $2 \leq (m + a + b) \leq 6$ and $1 \leq (a + b) \leq 5$.

[8] The method of preparing a lithographic printing plate as described in the [1] or the [2], wherein the photosensitive layer further contains (ii') an ethylenically unsaturated compound having at least one group selected film the group consisting of groups represented by formulae shown below:

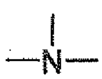

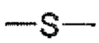

[9] The method of preparing a lithographic printing plate as described in the [1] or the [2], wherein the photosensitive layer further contains (ii') an ethylenically unsaturated compound having at least one group selected from the group consisting of groups represented by formulae shown below:

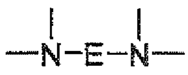

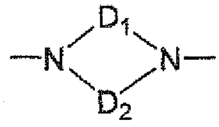

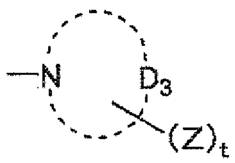

in formulae above, E represents (a) a divalent saturated hydrocarbon group, (b) an alicyclic group which may contain up to two atoms selected from the group consisting of a nitrogen atom, an oxygen atom and a sulfur atom in ring-forming atoms, (c) an arylene group or (d) a heterocyclic aromatic group, $D_1$ and $D_2$ each independently represents a saturated hydrocarbon group, $D_3$ represents a group which forms the ring together with the nitrogen atom and is composed of atoms selected from the group consisting of a carbon atom, an oxygen atom, a hydrogen atom, a nitrogen atom and a sulfur atom, t represents an integer from 1 to 10, and Z represents a hydrogen atom, a saturated hydrocarbon group or a group represented by formula shown below:

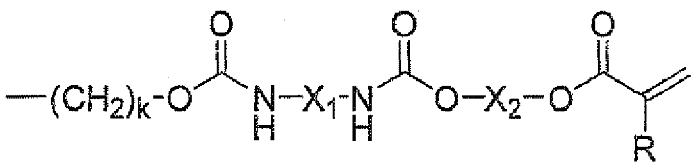

in formula above, $X_1$ represents a saturated hydrocarbon group or an aromatic hydrocarbon group, $X_2$ represents a saturated hydrocarbon group, an aromatic hydrocarbon group or a group represented by $-CH_2(O-Alk)_n-$, Alk represents an alkylene structure, n represents an integer from 1 to 50, R represents a hydrogen atom or a methyl group, and k represents an integer from 1 to 10.

[10] The method of preparing a lithographic printing plate as described in the above [8], wherein the ethylenically unsaturated compound (ii') is compound M-1 or M-2 shown below:

M-1 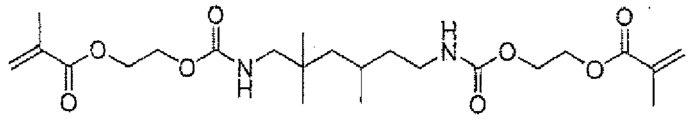

M-2 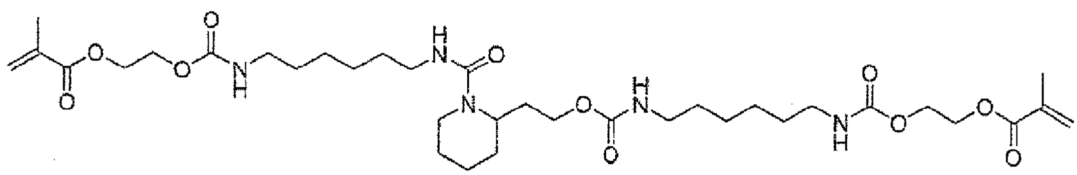

[11] The method of preparing a lithographic printing plate as described in any one of the [1] to the [10], wherein the binder polymer (i) is polyvinyl butyral.

[12] The method of preparing a lithographic printing plate as described in anyone of the [1] to the [10], wherein the binder polymer (i) is a mixture of polyvinyl butyral and a (meth)acrylic polymer.

[13] The method of preparing a lithographic printing plate as described in any one of the [1] to the [12], wherein the developer contains a water-soluble amine compound and an ion of the amine compound.

[14] The method of preparing a lithographic printing plate as described in the [13], wherein the water-soluble amine compound is at least one organic amine compound selected from the group consisting of monoethanolamine, diethanolamine, triethanolamine, N-hydroxyethylmorpholine and 4-dimethylaminopyridine.

[15] The method of preparing a lithographic printing plate as described in any one of the [1] to the [14], wherein the developer contains an organic solvent in an amount from 0.001 to 2.0% by weight.

[16] The method of preparing a lithographic printing plate as described in the 15, wherein the organic solvent is an organic solvent selected from the group consisting of an alcohol having from 6 to 20 carbon atoms.

[17] The method of preparing a lithographic printing plate as described in any one of the [1] to the [16], wherein the developer contains a nonionic surfactant.

[18] The method of preparing a lithographic printing plate as described in the 17, wherein the nonionic surfactant is a surfactant represented by formulae (I-A) or (I-B) shown below:

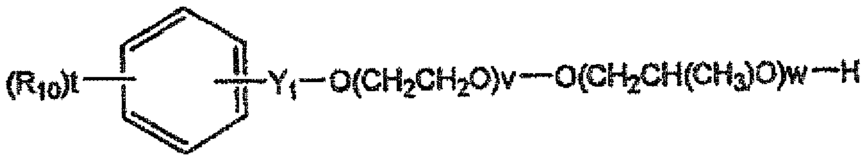

(I-A)

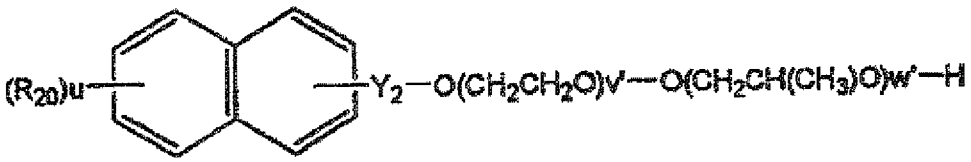

(I-B)

in formulae (I-A) and (I-B), $R_{10}$ and $R_{20}$ each independently represents a hydrogen atom or an organic group, t and u each independently represents 1 or 2, $Y_1$ and $Y_2$ each independently represents a single bond or an alkylene group, v and w each independently represents an integer from 0 to 100, provided that v and w are not 0 at the same time and that when one of v or w is 0, the other of v and w is not 1, v' and w' each independently represents an integer from 0 to 100, provided that v' and w' are not 0 at the same time and that when one of v' and w' is 0, the other of v' and w' is not 1, when t is 2 and $R_{10}$ represents an organic group, two $R_{10}$ may be the same or different or may be combined with each other to from a ring, and when u is 2 and $R_{20}$ represents an organic group, two $R_{20}$ may be the same or different or may be combined with each other to from a ring.

According to the present invention, a method of preparing a lithographic printing plate which is excellent not only in developing property, sensitivity and ink-receptive property but also in printing durability and reproducibility of halftone dot and inhibits the generation of development scum in a developer to be excellent in processing property can be provided.

BRIEF DESCRIPTION OF THE DRAWINGS

Fig. 1 is an illustration showing a structure of an automatic development processor.

[Description of reference numerals and signs]

11: Transporting path of lithographic printing plate precursor

100: Automatic development processor

200: Pre-heating unit

300: Developing unit

400: Drying unit

202: Machine casing

208: Heating chamber

210: Skewer roller

212: Transporting inlet

214: Heater

216: Circulation fan

218: Transporting outlet

304: Insertion roller pair

306: Processing tank

308: Developing tank

310: Outer panel

312: Slit type insertion slot

316: Submerged roller pair

318: Carrying-out roller pair

322: Brush roller pair

324: Shielding cover

326: Brush roller pair

330: Spray pipe

334: Slit type path-through slot

336: Liquid temperature sensor

338: Liquid level meter

332: Partition board

342: Guide member

344: Guide roller

402: Support roller

404: Discharge slot

406: Transport roller pair

408: Transport roller pair

410: Duct

412: Duct

414: Slit hole

50: External tank

51: Overflow aperture

52: Upper limit liquid level meter

53: Lower limit liquid level meter

54: Filter unit

55: Developer supply pump

C1: First circulation pipeline

C2: Second circulation pipeline

71: Water tank for replenishment

72: Water-replenishing pump

C3: Third circulation pipeline

## DETAILED DESCRIPTION OF THE INVENTION

The method of preparing a lithographic printing plate according to the invention comprises (A) an exposure step of exposing imagewise a lithographic printing plate precursor comprising a hydrophilic support, a photosensitive layer containing (i) a binder polymer, (ii) an ethylenically unsaturated compound having a hydrophilic group selected from the group consisting of at least one of an acid group and a salt thereof, an onium salt and a polyalkyleneoxy group and (iii) a polymerization initiator and a protective layer in this order, and (B) a development step of removing an unexposed area of the photosensitive layer and the protective layer of the lithographic printing plate precursor with a one bath using a developer having pH from 2 to 11.

The functional mechanism of the invention is not quite clear but it is presumed as follows. An Ethylenically unsaturated compound is deeply involved in developing property and sensitivity of a lithographic printing plate precursor and printing durability of a lithographic printing plate. When hydrophilicity of the ethylenically unsaturated compound is increased, the developing property and dispersibility of development scum are improved, but the sensitivity and printing durability are deteriorated. It is presumed that this is caused by increase in permeability of a developer into the image area and compatibility with a binder polymer.

Heretofore, from the standpoint of printing durability, a hydrophobic (meth)acryloyl compound has been preferably used as the ethylenically unsaturated compound. It is believed that such a compound becomes hydrophilic, for example, upon partial hydrolysis of an ester linkage and the like of the ethylenically unsaturated compound in a developer having a high basicity (for example, having pH of about 12) so that the occurrence of development scum is small in the development processing. On the other hand, it is believed that in a low alkaline development system, since the hydrolysis reaction or the like of the hydrophobic ethylenically unsaturated compound hardly proceeds, dispersion and solubilization of the hydrophobic ethylenically unsaturated compound is unable to progress effectively to be apt to generate the development scum.

According to the invention, it is believed that by using the ethylenically unsaturated compound having the specific hydrophilic group, the ethylenically unsaturated compound can be dispersed in the developer and the generation of development scum can be inhibited while maintaining other performances. It is also believed that, both the inhibition of development scum and good printing durability are achieved by using a photo-oxidizable group which is believed to improve photo-reactivity or photo-curability at the time of exposure or a unit which is believed to have strong cohesion, for example, a urethane group, a urea group, a thiourethane group or a urethane oligomer is used together with the hydrophilic unit.

<Lithographic printing plate precursor>

With respect to the lithographic printing plate precursors, particularly, photopolymerizable lithographic printing plate precursor for use in the invention, the constructions thereof will be described in order below.

[Support]

A support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

The center line average roughness of the support is preferably from 0.10 to 1.2 $\mu$m. In the range described above, good adhesion property to the photosensitive layer, good printing durability and good resistance to stain are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

[Hydrophilizing treatment of support and undercoat layer]

As for the lithographic printing plate precursor according to the invention, in order to increase hydrophilicity of the non-image area and to prevent printing stain, it is preferred to conduct a hydrophilizing treatment of the surface of support. It is also preferred to provide an undercoat layer between the support and the photosensitive layer.

The hydrophilizing treatment of the surface of support includes an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. It is preferred for the compound to further have a polymerizable group in order to increase the adhesion property to the photosensitive layer. As the polymerizable group, an ethylenically unsaturated bond group is preferred. Also, a compound further having a hydrophilicity-imparting group, for example, an ethyleneoxy group is exemplified as a preferable compound. These compounds may be low molecular weight compounds or polymer compounds. These compounds may be used in combination of two or more thereof, if desired.

For example, a silane coupling agent having an addition-polymerizable ethylenically unsaturated bond group described in JP-A-10-282679 and a phosphorus-containing compound having an ethylenically unsaturated bond group described in JP-A-2-304441 are preferably exemplified. It is also preferred to use a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263.

The undercoat layer is coated according a known method. The coating amount (solid content) of the undercoat layer is preferably from 0.1 to 100 mg/m$^2$, and more preferably from 1 to 30 mg/m$^2$.

[Backcoat layer]

The lithographic printing plate precursor for use in the invention may have a backcoat layer provided on the back surface of the support, if desired. The backcoat layer can be provided, for example, after applying the surface treatment to the support or forming the undercoat layer on the support.

The backcoat layer preferably includes, for example, a layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, $Si(OCH_3)_4$, $Si(OC_2H_5)_4$, $Si(OC_3H_7)_4$ or $Si(OC_4H_9)_4$ is preferred since the starting material is inexpensive and easily available.

[Photosensitive layer]

The photosensitive layer contains (i) a binder polymer, (ii) an ethylenically unsaturated compound having a

hydrophilic group selected from the group consisting of at least one of an acid group and a salt thereof, an onium salt and a polyalkyleneoxy group and (iii) a polymerization initiator.

[(i) Binder polymer]

As the binder polymer, a polymer capable of holding the components of photosensitive layer on a support and capable of being removed with a developer is used. The binder polymer used includes a (meth)acrylic polymer, polyurethane, polyvinyl alcohol, polyvinyl butyral, polyvinyl formal, polyamide, polyester and an epoxy resin. In particular, a (meth)acrylic polymer, polyurethane or polyvinyl butyral is preferably used. Plural different resins may be used in combination and a mixture containing polyvinyl butyral and a (meth)acrylic polymer is preferred.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane" as used herein means a polymer formed by a condensation reaction of a compound having two or more isocyanate groups and a compound having two or more hydroxy groups. The term "polyvinyl butyral" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group with a compound having the acid group or the like.

One preferable example of the (meth)acrylic polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit having an acid group, a repeating unit derived from (meth)acrylic acid or a repeating unit represented by formula (I) shown below is preferably used.

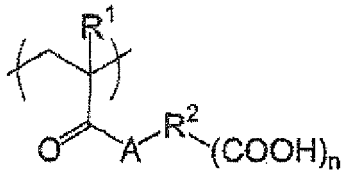

(I)

In formula (I), $R^1$ represents a hydrogen atom or a methyl group, $R^2$ represents a single bond or an (n+1) valent connecting group, A represents an oxygen atom or $NR^3$-, wherein $R^3$ represents a hydrogen atom or a monovalent hydrocarbon group having from 1 to 10 carbon atoms, and n represents an integer from 1 to 5.

The connecting group represented by $R^2$ in formula (I) is preferably constructed from one or more atoms selected from the group consisting of a hydrogen atom, a carbon atom, an oxygen atom, a nitrogen atom, a sulfur atom and a halogen atom and the number of atoms constituting the connecting group represented by $R^2$ is preferably from 1 to 80. Specific examples of the connecting group include an alkylene group, a substituted alkylene group, an arylene group and a substituted arylene group. The connecting group may have a structure wherein a plurality of such divalent groups is connected to each other via any of an amido bond, an ether bond, a urethane bond, a urea bond and an ester bond. $R^2$ is preferably a single bond, an alkylene group, a substituted alkylene group or a structure where a plurality of at least one of an alkylene group and a substituted alkylene group is connected to each other via any of an amido bond, an ether bond, a urethane bond, a urea bond and an ester bond, particularly preferably a single bond, an alkylene group having from 1 to 5 carbon atoms, a substituted alkylene group having from 1 to 5 carbon atoms or a structure where a plurality of an alkylene group having from 1 to 5 carbon atoms or a substituted alkylene group having from 1 to 5 carbon atoms is connected to each other via any of an amido bond, an ether bond, a urethane bond, a urea bond and an ester bond, and most preferably a single bond, an alkylene group having from 1 to 3 carbon atoms, a substituted alkylene group having from 1 to 3 carbon atoms or a structure where a plurality of an alkylene group having from 1 to 3 carbon atoms or a substituted alkylene group having from 1 to 3 carbon atoms is connected to each other via any of an amido bond, an ether bond, a urethane bond, a urea bond and an ester bond.

Examples of the substituent in the substituted alkylene group or substituted arylene group include a monovalent non-metallic atomic group exclusive of a hydrogen atom, for example, a halogen atom (e.g., -F, -Br, -Cl or -I), a hydroxy group, a cyano group, an alkoxy group, an aryloxy group, a mercapto group, an alkylthio group, an arylthio group, an alkylcarbonyl group, an arylcarbonyl group, a carboxyl group and a conjugate base group thereof, an alkoxycarbonyl group, an aryloxycarbonyl group, a carbamoyl group, an aryl group, an alkenyl group and an alkynyl group.

$R^3$ is preferably a hydrogen atom or a hydrocarbon group having from 1 to 5 carbon atoms, particularly preferably

a hydrogen atom or a hydrocarbon group having from 1 to 3 carbon atoms, and most preferably a hydrogen atom or a methyl group. n is preferably from 1 to 3, particularly preferably 1 or 2, and most preferably 1.

A ratio (% by mole) of the repeating unit having a carboxylic acid group in the total repeating units constituting the (meth)acrylic polymer is preferably from 1 to 70% by mole in view of developing property. Considering good compatibility between the developing property and printing durability, it is more preferably from 1 to 50% by mole, and particularly preferably from 1 to 30% by mole.

Preferable specific examples of the repeating unit having a carboxylic acid group are set forth below.

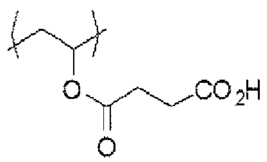
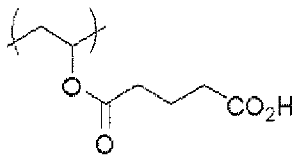
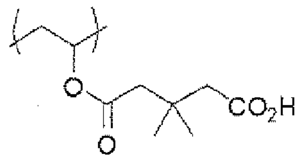

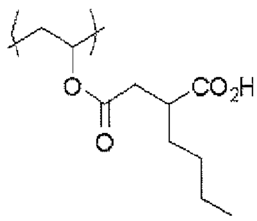
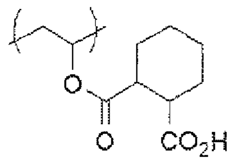
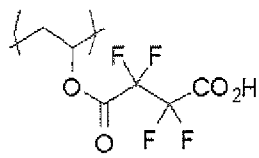
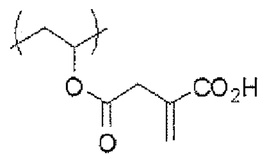

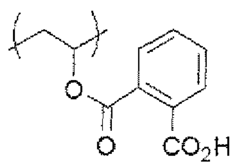
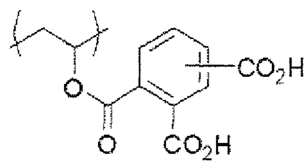
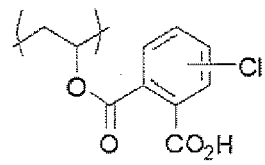

It is preferred that the (meth)acrylic polymer for use in the invention further contain a crosslinkable group. The term "crosslinkable group" as used herein means a group capable of crosslinking the binder polymer in the process of a radical polymerization reaction which is caused in the photosensitive layer, when the lithographic printing plate precursor is exposed to light The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the (meth)acrylic polymer, for example, a free radical (a polymerization initiating radical or a propagating radical in the process of polymerization of the polymerizable compound) is added to the crosslinkable functional group to cause an addition-polymerization, between the polymers directly or through a polymerization chain of the polymerizable compound, as a result, crossking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the (meth)acrylic polymer is preferably from 0.01 to 10.0 mmol, more preferably from 0.05 to 9.0 mmol, and most preferably from 0.1 to 8.0 mmol, per g of the (meth)acrylic polymer.

The (meth)acrylic polymer for use in the invention may contain a polymerization unit of an alkyl or aralkyl ester of (meth)acrylic acid, a polymerization unit of (meth)acrylamide or a derivative thereof, a polymerization unit of an α-hydroxymethylacrylate or a polymerization unit of a styrene derivative, in addition to the polymerization unit having an

acid group and the polymerization unit having a crosslinkable group described above. The alkyl group in the alkyl eater of (meth)acrylic acid is preferably an alkyl group having from 1 to 5 carbon atoms or an alkyl group substituted with the substituent described above having from 2 to 8 carbon atoms and more preferably a methyl group. The aralkyl ester of (meth)acrylic acid includes, for example, benzyl (meth)acrylate. The (meth)acrylamide derivative includes, for example, N-isopropylacrylamide, N-phenylmethacrylamide, N-(4-methoxycarbonylphenyl)methacrylamide, NN-dimethylacrylamide and morpholinoacrylamide. The α-hydroxymethylacrylate includes, for example, ethyl α-hydroxymethylacrylate and cyclohexyl α-hydroxymethylacrylate. The styrene derivative includes, for example, styrene and 4-tert-butylstyrene.

Preferable examples of the polyurethane according to the invention include polyurethanes described in Paragraph Nos. [0038] to [0039] of JP-A-2007-187836, Paragraph Nos. [0040] to [0041] of JP-A-2008-276155, Paragraph Nos. [0042] to [0043] of JP-A-2005-250438 and Paragraph Nos. [0044] to [0045] of JP-A-2005-250158.

Preferable examples of the polyvinyl butyral according to the invention include polyvinyl butyrals described in Paragraph Nos. [0047] to [0048] of JP-A-2001-75279.

Further, polyvinyl butyral having an acid group introduced, for example, polyvinyl butyral represented by formula (II) shown below is also preferably used.

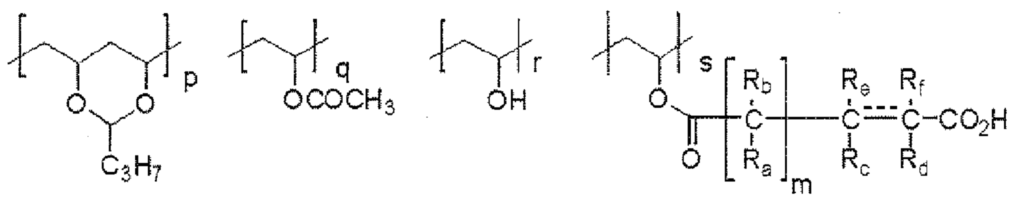

(II)

In formula (II), a ratio of each repeating unit p/q/r/s is preferably in a range from 50 to 78% by mole/from 1 to 5% by mole/from 5 to 28% by mole/from 5 to 20% by mole. $R_a$, $R_b$, $R_c$, $R_d$, $R_e$ and $R_f$ each independently represents a hydrogen atom, a monovalent substituent which may have a substituent or a single bond, and m represents an integer from 0 to 1. Preferable examples of any one of $R_a$, $R_b$, $R_c$, $R_d$, $R_e$ and $R_f$ include a hydrogen atom, an alkyl group which may have a substituent, a halogen atom and an aryl group which may have a substituent. More preferable examples thereof include a hydrogen atom, a straight-chain alkyl group, for example, a methyl group, an ethyl group or a propyl group, an alkyl group substituted with a carboxylic acid, a halogen atom, a phenyl group and a phenyl group substituted with a carboxylic acid. $R_c$ and $R_d$ or $R_e$ and $R_f$ may be combined with each other to form a ring structure. The bond between the carbon atom to which $R_c$ and $R_c$ connect and the carbon atom to which $R_d$ and $R_f$ connect is a single bond, a double bond or an aromatic double bond and in the case of the double bond or aromatic double bond, $R_c$ and $R_d$, $R_e$ and $R_f$, $R_c$ and $R_f$ or $R_e$ and $R_d$ are connected with each other to form a single bond.

The polyvinyl butyral represented by formula (II) can be obtained, for example, by reacting a hydroxy group of a polymer synthesized by a reaction (acetalization reaction) of polyvinyl alcohol obtained by partial or full saponification of polyvinyl acetate with butylaldehyde under an acidic condition with a compound represented by formula (II') shown below in a known manner. In formula (II'), $R_a$, $R_b$, $R_c$, $R_d$, $R_e$, $R_f$ and m have the same meanings as $R_a$, $R_b$, $R_c$, $R_d$, $R_e$, $R_f$ and m as defined in formula (II), respectively.

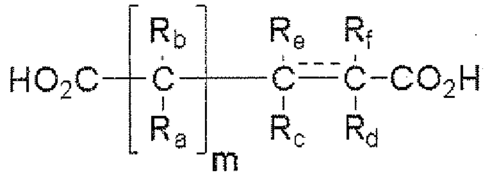

(II')

Moreover, the acid group of a polymer having an acid group which is a preferable example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

Further, the basic compound includes, for example, a basic nitrogen-containing compound, an alkali metal hydroxide and a quaternary ammonium salt of alkali metal.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property.

[(ii) Ethylenically unsaturated compound having hydrophilic group selected from the group consisting of at least one of acid group and salt thereof, onium salt and polyalkyleneoxy group]

According to the invention, the polymerizable compound (hereinafter, also referred to as an "addition-polymerizable compound") used in the photosensitive layer includes an ethylenically unsaturated compound (hereinafter, also referred to as an "ethylenically unsaturated compound (ii)") having a hydrophilic group selected from the group consisting of at least one of an acid group and a salt thereof, an onium salt and a polyalkyleneoxy group.

The ethylenically unsaturated compound (ii) is selected from compounds having at least one, preferably two or more, ethylenically unsaturated bonds and a hydrophilic group selected from the group consisting of at least one of an acid group and a salt thereof, an onium salt and a polyalkyleneoxy group.

Preferable specific examples of at least one of the acid group and a salt thereof includes at least one of a carboxylic acid group and a salt thereof, at least one of a sulfonic acid group and a salt thereof at least one of a phosphonic acid group and a salt thereof and at least one of a phosphoric acid group and a salt thereof. Specific examples of the salt structure include an alkali metal salt, for example, sodium salt, potassium salt or lithium salt, an alkaline earth metal salt, for example, magnesium salt or calcium salt, aluminum salt, boron salt and zinc salt, and an alkali metal salt, for example, sodium salt, potassium salt or lithium salt is preferred and sodium salt is most preferred.

Specific examples of the onium salt include an ammonium salt, a phosphonium salt, a sulfonium salt and an iodonium salt, and an ammonium salt is preferred. Specific examples of a counter ion of the onium salt include a halide ion, a carboxylate ion and a sulfonate ion, and the halide ion is preferred.

Preferable specific examples of the polyalkyleneoxy group include a poly(ethyleneoxy) group represented by formula (i) shown below, a poly(propyleneoxy) group represented by formula (ii) shown below, a poly(butyleneoxy) group represented by formula (iii) shown below and a combination thereof, and a poly(ethyleneoxy) group or a poly(propyleneoxy) group is more preferred and a poly(ethyleneoxy) group is most preferred.

$-(CH_2CH_2O)_n-$ (i)

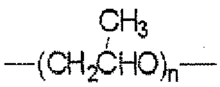 (ii)

$-(CH_2CH_2CH_2CH_2O)_n-$ (iii)

In formulae (i) to (iii), n represents an integer of 2 or more. In case of a mixture of the compounds, n indicates an average value. n is preferably from 2 to 20, more preferably from 2 to 11 from the standpoint of dispersibility of scum and printing durability, and most preferably from 3 to 8 from the standpoint of reproducibility of halftone dot.

As the hydrophilic group, from the standpoint of developing property, printing durability and reproducibility of halftone dot, a polyalkyleneoxy group is particularly preferred and a polyethyleneoxy group is most preferred.

The ethylenically unsaturated compound (ii) includes esters or amides of an unsaturated carboxylic acid (for example, acrylic acid, methacrylic acid, itaconic acid, crotonic acid, isocrotonic acid or maleic acid) having the hydrophilic group described above. Among them, compounds having at least one of an acryloyloxy group and a methacryloyloxy group are preferred.

From the standpoint of dispersibility of scum, printing durability and reproducibility of halftone dot, a log P value of the Ethylenically unsaturated compound (ii) is preferably from -1.00 to 3.50, more preferably from 0.00 to 3.50, and particularly preferably from 1.00 to 3.00.

The log P value means a common logarithm of partition coefficient P, and is a physical property value indicating, as a quantitative value, how a certain organic compound is distributed. at equilibrium in a two-phase system of oil (herein, 1-octanol) and water as shown below. Since when the value is higher, it is meant that the compound is more hydrophobic, whereas when the value is lower, it is meant that the compound is more hydrophilic, the value is used as an index for indicating the hydrophilic-hydrophobic property of compound. Thus, in the invention, as the value becomes higher, it becomes disadvantageous in view of the dispersibility of scum and on the other hand, as the value becomes lower, it becomes disadvantageous in view of the printing durability.

log P = log(Coil/Cwater)

wherein Coil represents a mol concentration of the compound in the oil phase and Cwater represents a mol concentration of the compound in the aqueous phase.

The log P value is used as one of the important indexes for knowing physiological activity and possibility of biological concentration of many drugs, and it is actually measured by a flask shaking method or an HPLC method or it

is estimated by calculation. In case of conducting the estimation by calculation, it is estimated by using a program, for example, ChemBioDraw ultra ver. 11 by CambridgeSoft Corp. and Bio-Loom version 5 by BioByte Corp. each of which is one of the most versatile applications for chemical structural formula drawing and analysis for one skilled in the art, or ALOGPS 2.1 Program and SPARC On Line Calculator, each of which is available for free on web site.

The ethylenically unsaturated compound (ii) is preferably a compound having at least one group (hereinafter, also referred to as a "photo-oxidizable group (A)") selected from the group consisting of groups represented by formulae shown below, from the standpoint of photo-curability and printing durability.

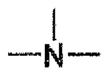

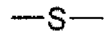

The photo-oxidizable group (A) is preferably at least one group selected from the group consisting of groups represented by formulae shown below.

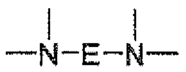

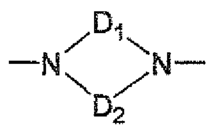

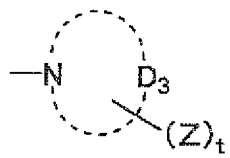

In formulae above, E represents (a) a divalent saturated hydrocarbon group, (b) an alicyclic group which may contain up to two atoms selected from the group consisting of a nitrogen atom, an oxygen atom and a sulfur atom in ring-forming atoms, (c) an arylene group or (d) a heterocyclic aromatic group.

The divalent saturated hydrocarbon group for E may be straight-chain or branched, and is preferably a saturated hydrocarbon group having from 2 to 12 carbon atoms. Specific examples thereof include an ethylene group, a propylene group, a butylene group, a hexylene group and an octylene group.

The alicyclic group for E is preferably a 5-membered to 7-membered alicyclic group. Specific examples thereof include a cyclopentylene group, a cyclohexylene group and a cycloheptylene group.

The arylene group for E is preferably an arylene group having from 6 to 12 carbon atoms. Specific examples thereof include a phenylene group, a tolylene group and a naphthylene group.

The heterocyclic aromatic group for E is preferably a heterocyclic aromatic group having from 5 to 10 carbon atoms- Specific examples thereof include groups derived from furan, thiophene, pyrrole, imidazole and pyridine.

$D_1$ and $D_2$ each independently represents a saturated hydrocarbon group.

$D_3$ represents a group which forms the ring together with the nitrogen atom and is composed of atoms selected from the group consisting of a carbon atom, an oxygen atom, a hydrogen atom, a nitrogen atom and a sulfur atom.

The saturated hydrocarbon group for $D_1$ or $D_2$ may be straight-chain or branched, and is preferably a saturated hydrocarbon group having from 1 to 5 carbon atoms. Specific examples thereof include a methylene group, an ethylene group, a propylene group and a butylene group.

The ring formed by $D_3$ together with the nitrogen atom is preferably 5-membered or 6-membered ring.

t represents an integer from 1 to 10.

Z represents a hydrogen atom, a saturated hydrocarbon group or a group represented by a formula shown below.

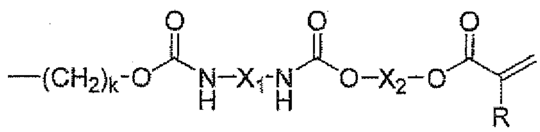

In formula above, $X_1$ represents a saturated hydrocarbon group or an aromatic hydrocarbon group.

$X_2$ represents a saturated hydrocarbon group, an aromatic hydrocarbon group or a group represented by $-CH_2(O\text{-}Alk)_n-$. Alk represents an alkylene group. n represents an integer from 1 to 50.

R represents a hydrogen atom or a methyl group.

k represents an integer from 1 to 10.

The saturated hydrocarbon group for Z may be straight-chain or branched, and is preferably a saturated hydrocarbon group having from 1 to 3 carbon atoms. Specific examples thereof include a methyl group, an ethyl group, a n-propyl group and an isopropyl group.

t represents an integer from 1 to 10, preferably represents an integer from 1 to 5, and more preferably represents an integer from 1 to 3.

The saturated hydrocarbon group for $X_1$ may be straight-chain or branched, and is preferably a saturated hydrocarbon group having from 6 to 26 carbon atoms. Specific examples thereof include a n-hexylene group, an isohexylene group, a tert-hexylene group, a n-heptylene group, an isoheptylene group, a tert-heptylene group, a n-octylene group, an isooctylene group, a tert-octylene group, a n-nonylene group, an isononylene group, a tert-nonylene group, a n-decylene group, an isodecylene group, a tert-decylene group, a n-undecylene group, an isoundecylene group, a n-dodecylene group, an isododecylene group, a n-tridecylene group, an isotridecylene group, a n-tetradecylene group, an isotetradecylene group, a n-pentadecylene group, an isopentadecylene group, a n-hexadecylene group, an isohexadecylene group, a n-heptadecylene group, an isoheptadecylene group, a n-octadecylene group, an isooctadecylene group, a n-nonadecylene group and an isononadecylene group.

The saturated hydrocarbon group for $X_2$ may be straight-chain or branched, and is preferably a saturated hydrocarbon group having from 2 to 9 carbon atoms. Specific examples thereof include an ethylene group, a propylene group, a butylene group, a hexamethylene group and a trimethylhexamethylene group.

The aromatic hydrocarbon group for $X_1$ or $X_2$ is preferably an aromatic hydrocarbon group having from 6 to 24 carbon atoms. Specific examples thereof include a phenylene group, a tolylene group and a xylylene group.

The alkylene group for Alk is preferably an ethylene group, a propylene group (including a n-propylene group and an isopropylene group) or a butylene group, and more preferably an ethylene group.

n is preferably an integer from 10 to 40, and more preferably an integer from 20 to 30.

k represents an integer from 1 to 10, preferably represents an integer from 1 to 5, and more preferably represents an integer from 2 to 4.

The ethylenically unsaturated compound (ii) is preferably a compound having a urethane group, a urea group or a thiourethane group from the standpoint of printing durability. These groups have high cohesion energy and are able to increase the strength of cured layer after light irradiation.

The ethylenically unsaturated compound (ii) is more preferably an oligomer having a weight average molecular weight from 1,000 to 10,000 from the standpoint of printing durability.

The ethylenically unsaturated compound (ii) is more preferably a compound represented by formula (I) shown below from the standpoint of dispersibility of scum and printing durability.

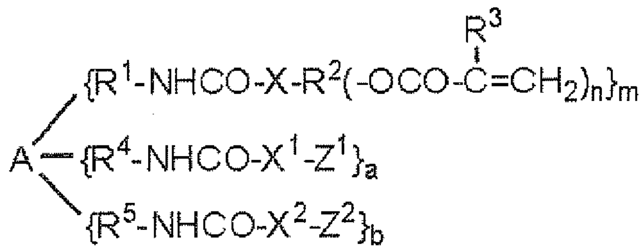

(I)

In formula (I), A represents a group a) or b) shown below:

a) a 2- to 6-valent hydrocarbon residue (preferably having from 5 to 25 carbon atoms) which may contain one or more ether bonds, ester bonds and amido bonds;
b) a 2- or 3-valent urea residue;

X, $X^1$ and $X^2$ each independently represents -O- or -NR-, R represents an alkyl group (preferably having from 1 to 12 carbon atoms),

$R^1$, $R^4$ and $R^5$ each independently represents a divalent hydrocarbon residue (preferably having from 1 to 25 carbon atoms), $R^2$ represents a 2- to 6-divalent straight chain or branched hydrocarbon residue (preferably having from 2 to 18 carbon atoms), and $R^3$ represents a hydrogen atom or a methyl group.

$Z^1$ represents a hydrophilic group selected from the group consisting of at least one of an acid group and a salt thereof, an onium salt and a polyalkyleneoxy group. Specific examples of the acid group and salt thereof, onium salt and polyalkyleneoxy group are same as those described above.

$Z^2$ represents a hydrophobic group selected from the group consisting of an alkyl group, a cycloalkyl group, an arylalkyl group, an alkylaryl group, an aryl group, an alkoxy group, a fluoroalkyl group or a perfluoroalkyl group and

a silicone group.

The alkyl group, cycloalkyl group, arylalkyl group, alkylaryl group, aryl group, alkoxy group, fluoroalkyl group or perfluoroalkyl group may further have a substituent and in such a case, the substituent preferably has 4 or more carbon atoms.

n, m and a each independently represents an integer from 1 to 5, and b represents an integer from 0 to 5, provided that 2≤(m + a + b) ≤6 and 1 ≤(a + b) ≤5.

The compounds represented by formula (I) may be used individually or as a mixture of two or more thereof and are preferably used as a mixture of two or more thereof In the case where the compound represented by formula (I) is used as a mixture of two or more thereof, an amount of a meth(acrylate) group per 100 g of the mixture is preferably from 0.1 to 0.8% by mole, and more preferably from 0.15 to 0.6% by mole.

Specific examples M-9 to M-72 of the ethylenically unsaturated compound (ii) are set forth below, but the invention should not be construed as being limited thereto. The Clog P value attached to each compound is a Log P value calculated using the ChemBioDraw ultra ver. 11 or Bio-Loom version 5.

Compounds M-50 to M-62 represent urethane oligomers formed by condensation of an isocyanate compound described in the column of "NCO" with a hydrophilic compound described in the column of "Hydrophilic Group" and also as a copolymerization component, BD when described in the column of "Others", at the ratio of numerical values (molar ratio) described in the table, respectively. In the oligomer finally obtained, an amount of the monomer for forming the terminal of oligomer described in the column of "Terminal Group" is not described in the table as the ratio of numerical values (molar ratio) because the amount thereof is extremely small in comparison with the amounts of the compounds described in the columns of "NCO" and "Hydrophilic Group''.

M-9

M-10

M-11

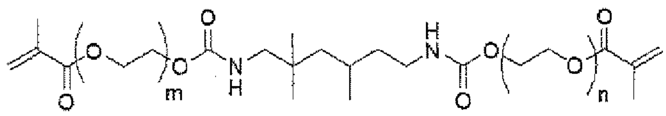

m+n=10 CLogP: 3.83

m+n=18 CLogP: 2.75

m+n=30 CLogP: 1.12

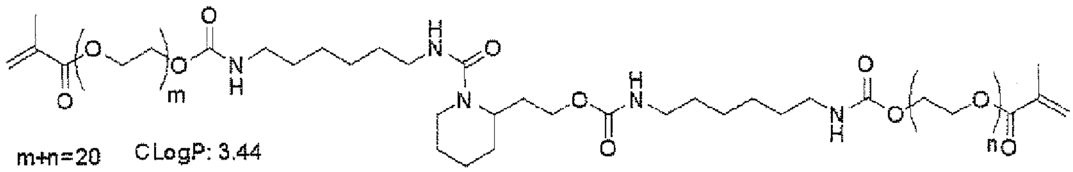

M-12 m+n=20 CLogP: 3.44

M-13 m+n=26 CLogP: 2.62

M-14

M-15

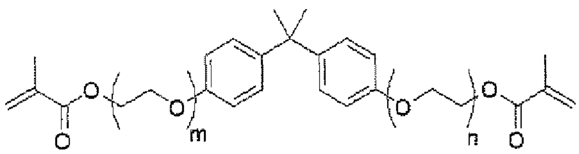

m+n = 20 CLogP: 4.40

m+n = 33 CLogP: 2.64

M-16

M-17

M-18

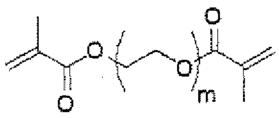

m = 1 CLogP: 1.74

m = 4 CLogP: 1.27

m = 8 CLogP: 0.65

M-19
M-20

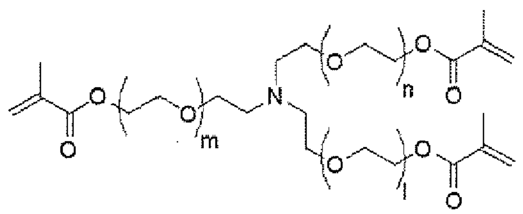

m + n + l = 15 CLogP: 2.76
m + n + l = 21 CLogP: 1.95

M-21
M-22

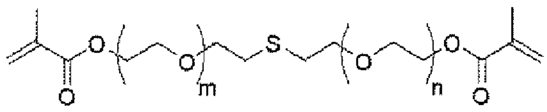

m + n = 4 CLogP: 2.6632
m + n = 8 CLogP: 2.1208

M-23
M-24

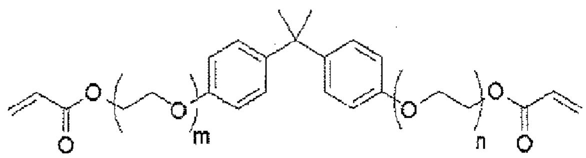

m+n = 20 CLogP: 3.79
m+n = 33 CLogP: 2.02

M-25
M-26

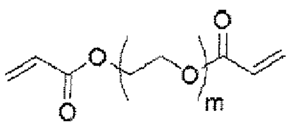

m = 1 CLogP: 1.36
m = 4 CLogP: 1.15
m = 8 CLogP: 0.61

M-27
M-28
M-29

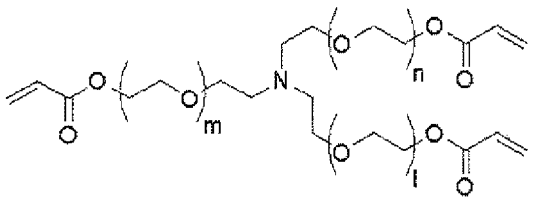

m + n + l = 15 CLogP: 1.83
m + n + l = 21 CLogP: 1.02

M-30
M-31

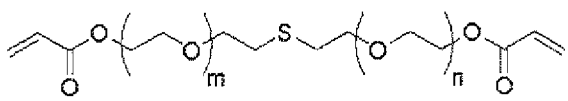

m + n = 4 CLogP: 2.05
m + n = 8 CLogP: 1.50

M-32
M-33
M-34

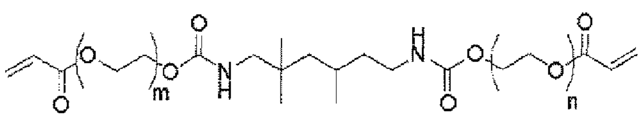

m+n=10 CLogP: 3.21
m+n=18 CLogP: 2.13
m+n=30 CLogP: 0.50

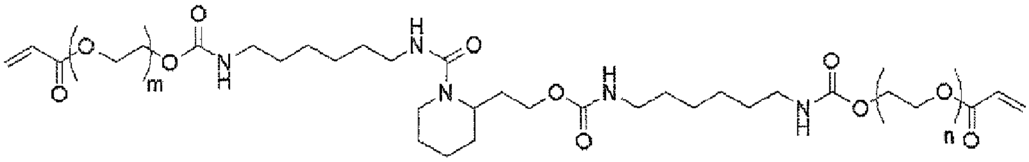

M-35 m+n=20 CLogP: 2.82

M-36 m+n=26 CLogP: 2.00

M-37

M-38

M-39

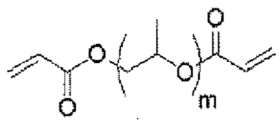

m = 1 CLogP: 1.67

m = 4 CLogP: 2.38

m = 8 CLogP: 3.08

M-40

M-41

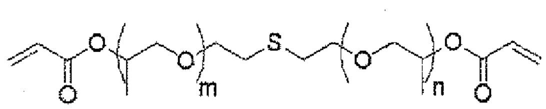

m + n = 2 CLogP: 2.66

m + n = 6 CLogP: 3.36

M-42

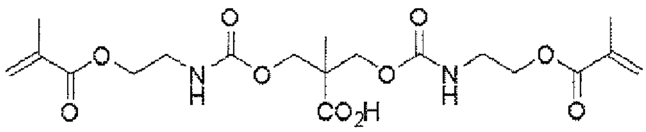

CLogP: 1.9806

M-43

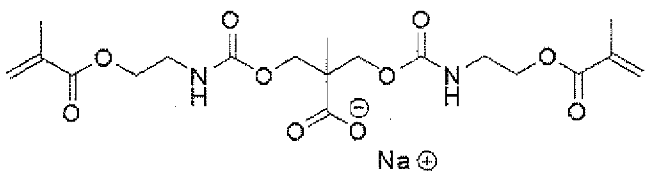

CLogP: 0.0605999

M-44

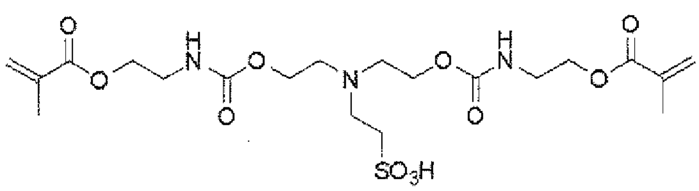

CLogP: -1.2242

M-45

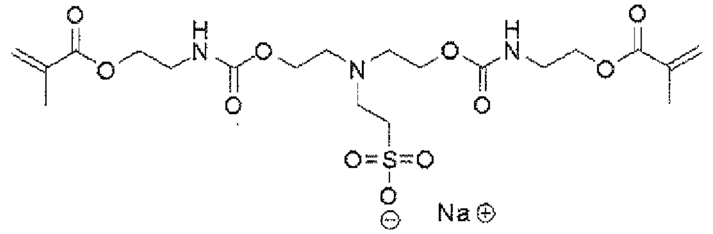

CLogP: -3.9622

M-46

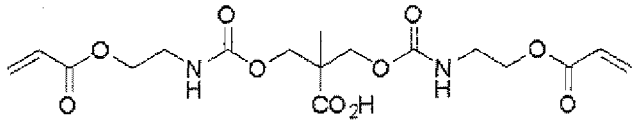

CLogP: 1.3626

M-47

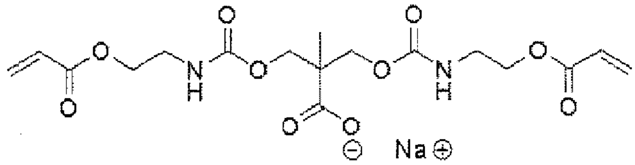

CLogP: -0.5574

M-48

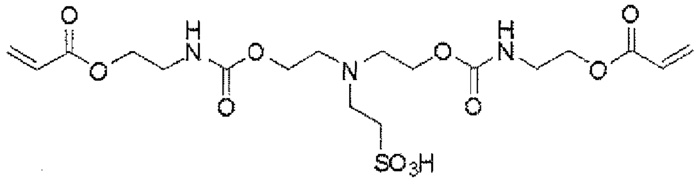

CLogP: -1.8422

M-49

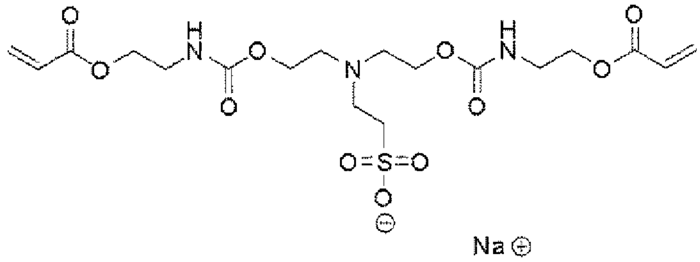

CLogP: -4.5802

MDI 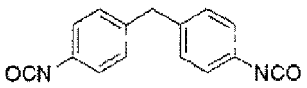

HDI 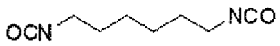

TDI 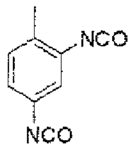

IPDI 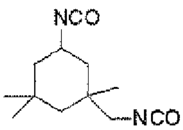

PEG-600 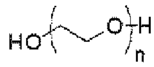

Mn=600

PPG-700 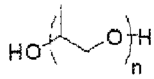

Mn=700

DMPA 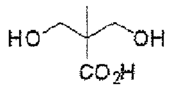

DMPA-Na 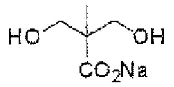

BD 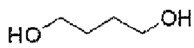

BES 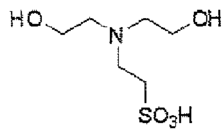

BES-Na 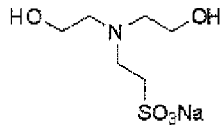

HEA 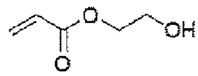

HEMA 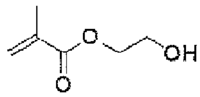

HPMA 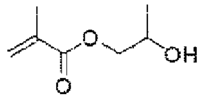

TABLE

| | NCO | Hydrophilic Group | Others | Terminal Group | Mw |
|---|---|---|---|---|---|
| M-50 | HDI 50 | PEG-600 50 | - | HEA | 5,000 |
| M-51 | HDI 50 | PEG-600 50 | - | HEMA | 5,000 |
| M-52 | HDI 50 | PEG-600 50 | - | HEMA | 2,000 |
| M-53 | HDI 50 | PEG-600 50 | - | HEMA | 10,000 |
| M-54 | HDI 50 | PEG-600 50 | - | HEMA | 5,000 |
| M-55 | MDI 50 | PEG-600 50 | - | HEMA | 5,000 |
| M-56 | IPDI 50 | PEG-600 50 | - | HEMA | 5,000 |
| M-57 | TDI 50 | PEG-600 50 | - | HEMA | 5,000 |
| M-58 | HDI 50 | PPG-700 50 | - | HEMA | 5,000 |
| M-59 | HDI 50 | DMPA 15 | BD 35 | HEMA | 5,000 |
| M-60 | HDI 50 | DMPA-Na 7 | BD 43 | HEMA | 5,000 |
| M-61 | HDI 50 | BES 5 | BD 45 | HEMA | 5,000 |
| M-62 | HDI 50 | BES-Na 5 | BD 45 | HEMA | 5,000 |

M-63

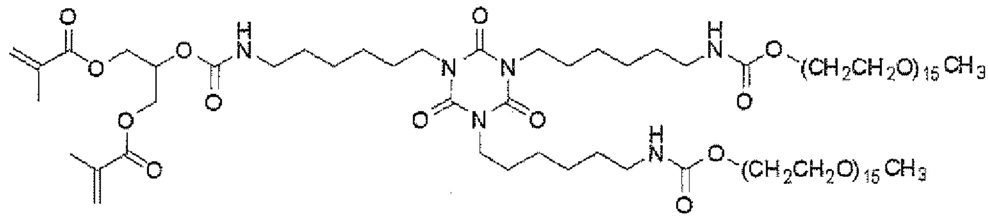

M-64

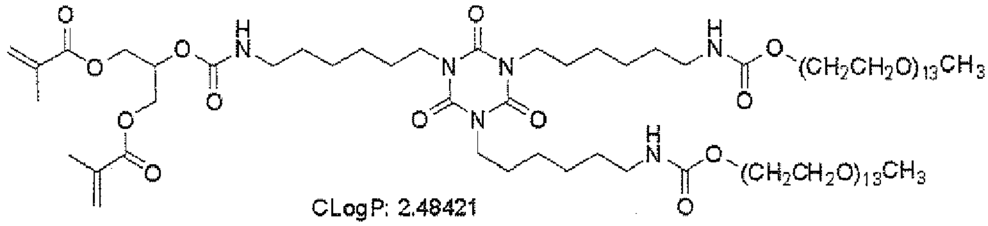

CLogP: 2.48421

M-65

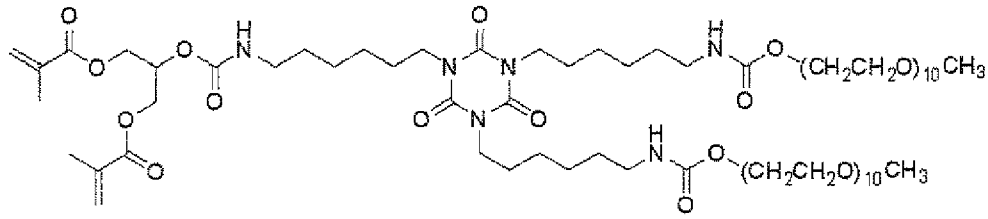

CLogP: 3.2978

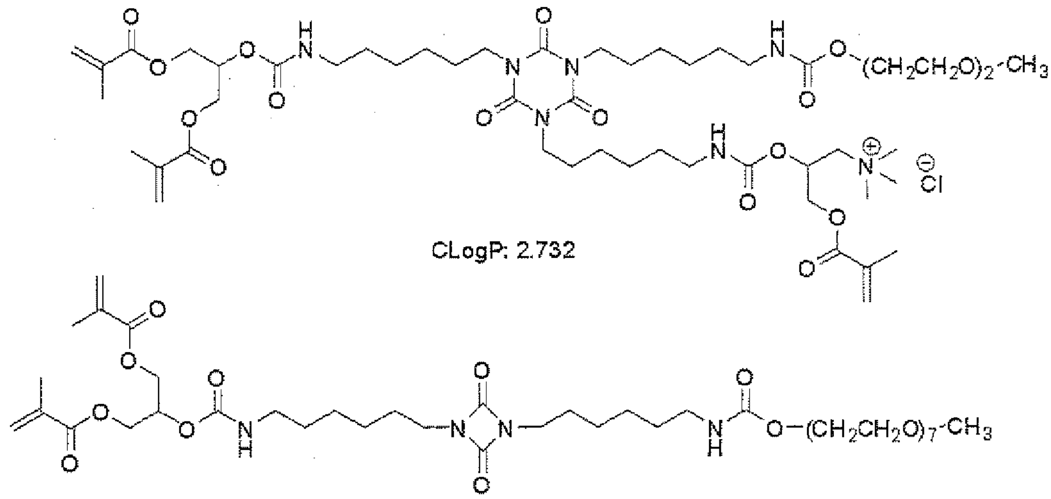

M-66

CLogP: 2.732

M-67

CLogP: 3.48

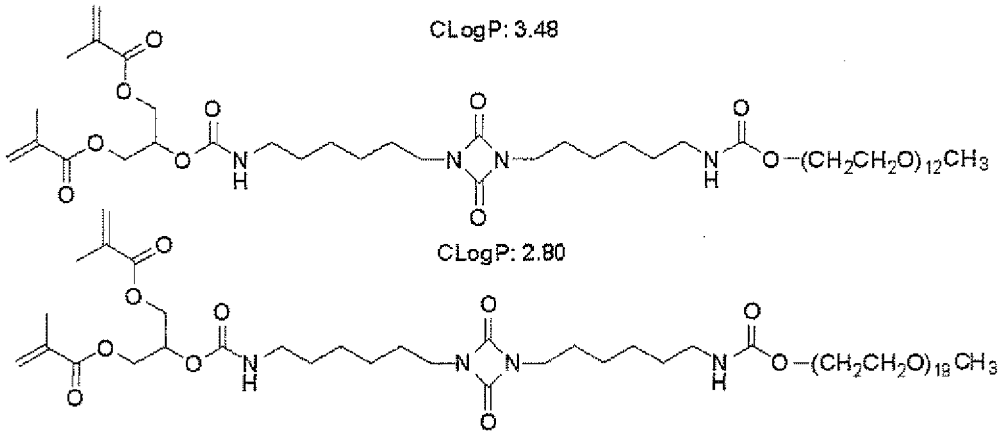

M-68

CLogP: 2.80

M-69

CLogP: 1.72

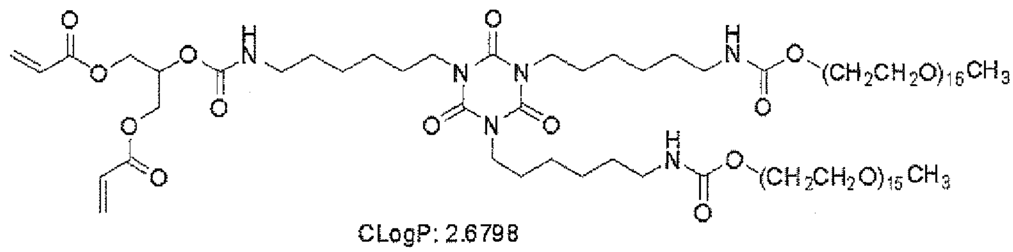

M-70

CLogP: 2.6798

M-71

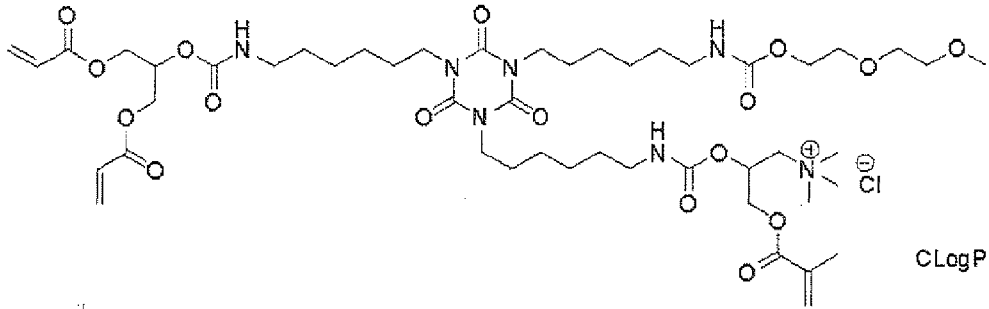

CLogP: 2.114

M-72

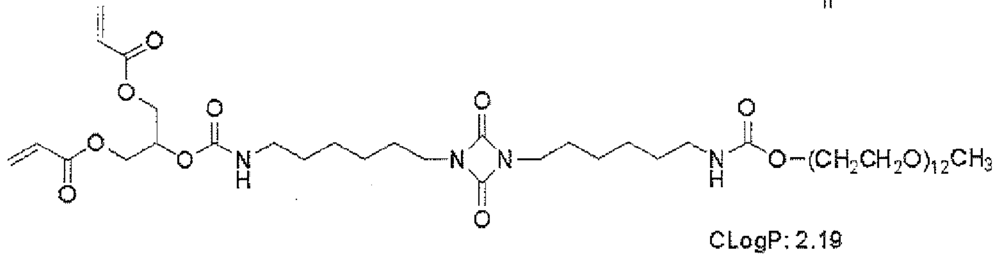

CLogP: 2.19

The ethylenically unsaturated compounds (ii) may be used individually or in combination of two or more thereof.

The content of the ethylenically unsaturated compound (ii) is ordinarily from 20 to 90% by weight, preferably from 30 to 80% by weight, based on the total solid content of the photosensitive layer.

(Other ethylenically unsaturated compound)

An Ethylenically unsaturated compound (hereinafter, also simply referred to as "other Ethylenically unsaturated compound") other than the ethylenically unsaturated compound (ii) may be used together as a polymerizable compound.

Examples of the ethylenically unsaturated compound which can be added other than the ethylenically unsaturated compound (ii) include esters or amides of an unsaturated carboxylic acid (for example, acrylic acid, methacrylic acid, itaconic acid, crotonic acid, isocrotonic acid or maleic acid). Preferably, esters of an unsaturated carboxylic acid with an aliphatic polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide having a nucleophilic substituent with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Among them, the Ethylenically unsaturated compound preferably has at least one of an acryloyloxy group and a methacryloyloxy group.

With respect to specific examples of the monomer, which is an ester of an aliphatic polyhydric alcohol compound with an unsaturated carboxylic acid, as an acrylic acid ester, for example, ethylene glycol diacrylate, triethylene glycol diacrylate, 1,3-butanediol diacrylate, tetraethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or a polyester acrylate oligomer is exemplified.

As a methacrylic acid ester, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or

bis[p-(methacryloxyethoxy)-phenyl]dimethylmethane is exemplified.

As an itaconic acid ester, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate is exemplified. As a crotonic acid ester, for example, ethylene glycol dicrotonate, tetramethylene glycol dicrotonate, pentaerythritol dicrotonate or sorbitol tetracrotonate is exemplified. As an isocrotonic acid ester, for example, ethylene glycol diisocrotonate, pentaerythritol diisocrotonate or sorbitol tetraisocrotonate is exemplified. As a maleic acid ester, for example, ethylene glycol dimaleate, triethylene glycol dimaleate, pentaerythritol dimaleate and sorbitol tetramaleate is exemplified.

Other examples of the ester, which can be preferably used, include aliphatic alcohol esters described in JP-B-46-27926 (the term "JP-B" as used herein means an "examined Japanese patent publication"), JP-B-51-47334 and JP-A-57-196231, esters having an aromatic skeleton described in JP-A-59-5240, JP-A-59-5241 and JP-A-2-226149, and esters containing an amino group described m JP-A-1-165613. The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25433 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used. Specifically, NK OLIGO U-4HA, NK OLIGO U-4H, NK OLIGO U-6HA, NK OLIGO U-6ELH, NK OLIGO U-108A, NK OLIGO U-1084A, NK OLIGO U-200AX, NK OLIGO U-122A, NK OLIGO U-340A, NK OLIGO UA-324A and NK OLIGO UA-100 (produced by Shin-Nakamura Chemical Co., Ltd.), UA-306H, AI-600, UA-101T, UA-101I, UA-306T and UA-306I (produced by Kyoeisha Chemical Co., Ltd.), ART RESIN UN-9200A, ART RESIN UN-3320HA, ART RESIN UN-3320HB, ART RESIN UN-3320HC, ART RESIN SH-380G, ART RESIN SH-500 and ART RESIN SH-9832 (produced by Negami Chemical Industrial Co., Ltd.) and PLEX 6661-O (produced by Degussa AG, Germany) are exemplified.

Details of the method of using the polymerizable compound, for example, selection of the structure, individual or combination use or an amount added, can be appropriately determined in accordance with the characteristic design of the final lithographic printing plate precursor. For instance, the compound is selected from the following standpoints. In view of the photosensitive speed, a structure having a large content of unsaturated group per molecule is preferred and in many cases, a difunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the photosensitivity and the strength. The compound having a large molecular weight or compound having high hydrophobicity is excellent in the photosensitive speed and film strength but may not be preferred in sometimes in view of developing speed and deposition in a developer. The selection and use method of the polymerizable compound are also important factors for the compatibility and dispersibility with other components (for example, a binder polymer, an initiator or a coloring agent) in the photosensitive layer. For instance, the compatibility may be improved in some cases by using the compound of low purity or using two or more kinds of the compounds in combination. A specific structure may be selected for the purpose of improving an adhesion property to the support, a protective layer described hereinafter or the like. With respect to the ratio of the polymerizable compound contained in the photosensitive layer, as the ratio increases, it is advantageous in the sensitivity, but when it is too large, problems of the occurrence of undesirable phase separation, troubles in the production step due to tackiness of the photosensitive layer (for example, transfer of the photosensitive layer component or production failure caused by the tackiness) and the occurrence of deposition in the developer may arise.

In addition, with respect to the method of using the polymerizable compound, the structure, blend and amount added can be appropriately selected by taking account of the degree of polymerization inhibition due to oxygen, resolution, fogging property, change in refractive index, surface tackiness and the like.

The other ethylenically unsaturated compounds may be used individually or in combination of two or more thereof.

When the other ethylenically unsaturated compound is used, the amount thereof added is ordinarily from 10 to 200% by weight, preferably from 50 to 150% by weight, based on the ethylenically unsaturated compound (ii).

As the other ethylenically unsaturated compound, an ethylenically unsaturated compound (ii') having at least

one of the photo-oxidizable groups (A) described above is particularly preferably used from the standpoint of development scum and printing durability. Preferred examples of the photo-oxidizable group (A) are same as those described above.

As a preferred compound of the ethylenically unsaturated compound (ii'), a compound represented by formula shown below is exemplified.

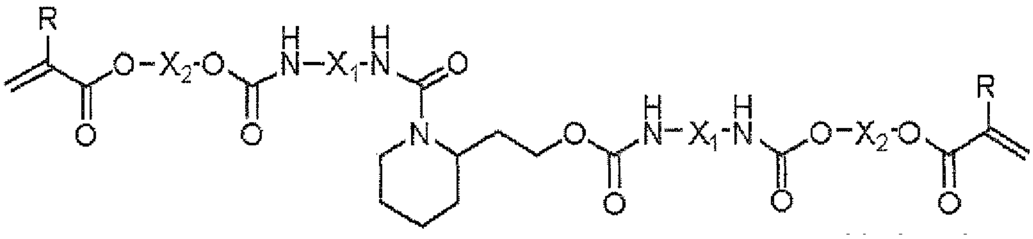

In formula above, $X_1$ each independently represents a saturated hydrocarbon group or an aromatic hydrocarbon group, $X_2$ each independently represents a saturated hydrocarbon group, an aromatic hydrocarbon group or a group represented by $-CH_2(O\text{-}Alk)_n-$, Alk represents an alkylene group, n represents an integer from 1 to 50, R each independently represents a hydrogen atom or a methyl group.

Specific examples of $X_1$, $X_2$ and Alk are same as those of $X_1$, $X_2$ and Alk described for Z in the photo-oxidizable group (A) above. The definition and specific examples of n are also same as those described for n in the photo-oxidizable group (A) above.

The amount of the ethylenically unsaturated compound (ii') added is ordinarily from 10 to 200% by weight, preferably from 50 to 150% by weight, based on the ethylenically unsaturated compound (ii).

As preferable specific examples of the ethylenically unsaturated compound (ii'), Compounds M-1 to M-8 are set for the below, but the invention should not be construed as being limited thereto. The Clog P value attached to each compound is a Log P value calculated using the ChemBioDraw ultra ver. 11 or Rio-Loom version 5.

M-1 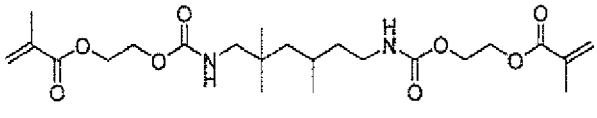 CLogP: 4.5154

M-2 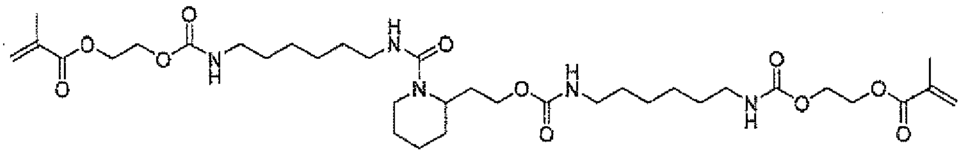

CLogP: 5.48

M-3 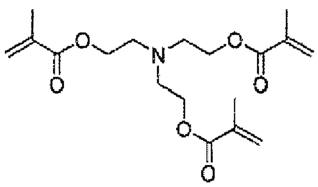

CLogP: 3.79

M-4 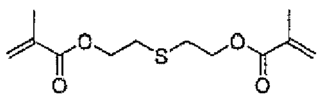

CLogP: 2.53

M-5 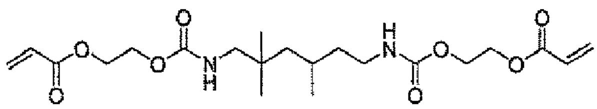 CLogP: 3.8974

M-6 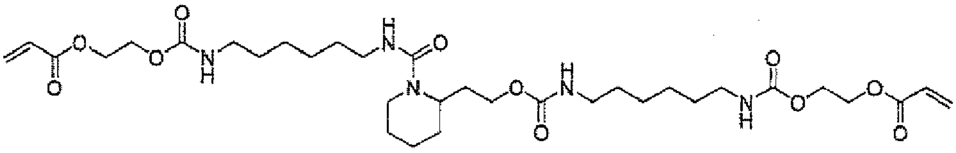

CLogP: 4.86

M-7 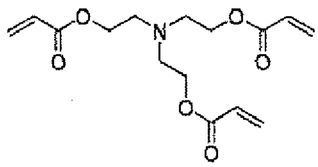

CLogP: 2.86

M-8 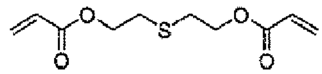

CLogP: 1.92

The total content of the all polymerizable compounds including the ethylenically unsaturated compound (ii) and the binder polymer is preferably 90% by weight or less based on the total solid content of the photosensitive layer. When it exceeds 90% by weight, decrease in the sensitivity and deterioration of the developing property may be caused sometimes. The total content is more preferably from 35 to 80% by weight.

According to the invention, by controlling a ratio of the polymerizable compound to the binder polymer contained in the photosensitive layer of the lithographic printing plate precursor, the permeability of developer into the photosensitive layer more increases and the developing property is further improved. Specifically, a weight ration of polymerizable compound including the ethylenically unsaturated compound (ii)/binder polymer in the photosensitive layer is preferably 1.2 or more, more preferably from 1.25 to 4.5, and most preferably from 1.5 to 4.

[polymerization initiator]

The photosensitive layer in the invention contains a polymerization initiator (hereinafter, also referred to as an initiator compound). In the invention, a radical polymerization initiator is preferably used.

As the initiator compound in the invention, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt and a iron arene complex. Among them, at least one compound selected from the hexaarylbiimidazole compound, onium salt, trihalomethyl compound and metallocene compound is preferred, and the hexaarylbiimidazole compound is particularly preferred. Two or more kinds of the polymerization initiator may be appropriately used in combination.

The bexaarylbiimidazole compound includes, for example, lophine dimers described in JP-B-45-37377 (the term "JP-B" as used herein means an "examined Japanese patent publication") and JP-B-44-86516, specifically, 2,2'-bis(o-chlorophenyl)-4,4',5,5'-tetraphenylbiimidazole, 2,2'-bis(o-bromophenyl)-4,4',5,5'-tetrapbenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(0-nitrophenyl)-4,4',5,5'-tetraphenylbiimidazole,
2,2'-bis(o-methylphenyl)-4,4',5,5'-tetraphenylbiimidazole and
2,2'-bis(o-trifluoromethylphenyl)-4,4',5,5'-tetraphenylbiimidazole.

The hexaarylbiimidazole compound is particularly preferably used together with the sensitizing dye having an absorption maximum at from 300 to 450 nm described above.

The onium salt preferably used in the invention includes a sulfonium salt, an iodonium salt and a diazonium salt. Particularly, a diaryliodonium salt or a triarylsulfonium salt is preferably used.

The onium salt is particularly preferably used together with the infrared absorbing agent having an absorption maximum at from 750 to 1,400 nm described above.

In addition, polymerization initiators described in Paragraph Nos. [0071] to [0129] of JP-A-2007-206217 are preferably used.

The polymerization initiators are preferably used individually or in combination of two or more thereof.

The amount of the polymerization initiator used in the photosensitive layer is preferably from 0.01 to 20% by

weight, more preferably from 0.1 to 15% by weight, still more preferably from 1.0 to 10% by weight, based on the weight of the total solid content of the photosensitive layer.

(Sensitizing dye)

The photosensitive layer according to the invention preferably contains a sensitizing dye. The sensitizing dye can be used without particular restriction as far as it absorbs light at the image exposure to form the excited state and provides energy to the polymerization initiator described above with electron transfer, energy transfer or heat generation thereby improving the polymerization initiation function. Particularly, a sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include merocyanine dyes, benzopyranes, coumarins, aromatic ketones, anthracenes, styryls and oxazoles.

Of the sensitizing dyes having an absorption maximum in a wavelength range from 300 to 450 nm, a dye represented by formula (IX) shown below is more preferred in view of high sensitivity.

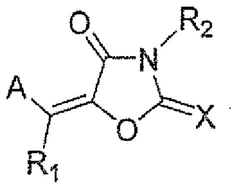

(IX)

In formula (IX), A represents an aryl group which may have a substituent or a heteroaryl group which may have a substituent, X represents an oxygen atom, a sulfur atom or $=N(R_3)$, and $R_1$, $R_2$ and $R_3$ each independently represents a monovalent non-metallic atomic group, or A and $R_1$ or $R_2$ and $R_3$ may be combined with each other to form an aliphatic or aromatic ring.

The formulae (IX) will be described in more detail below. $R_1$, $R_2$ and $R_3$ each independently represents a monovalent non-metallic atomic group, preferably a hydrogen atom, a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

A represents an aryl group which may have a substituent or a heteroaryl group which may have a substituent and the aryl group which may have a substituent and heteroaryl group which may have a substituent are same as the substituted or unsubstituted aryl group and substituted or unsubstituted heteroaryl group described for any one of $R_1$, $R_2$ and $R_3$ in formula (IX), respectively.

Specific examples of the sensitizing dye preferably used include compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816.

Further, sensitizing dyes described in JP-A-2006-189604, JP-A-2007-171406, JP-A-2007-206216, JP-A-2007-206217, P-A-2007-225701, JP-A-2007-225702, JP-A-2007-316582 and JP-A-2007-328243 are also preferably used.

Further, a sensitizing dye represented by formula (V) or (VI) shown below can also be used.

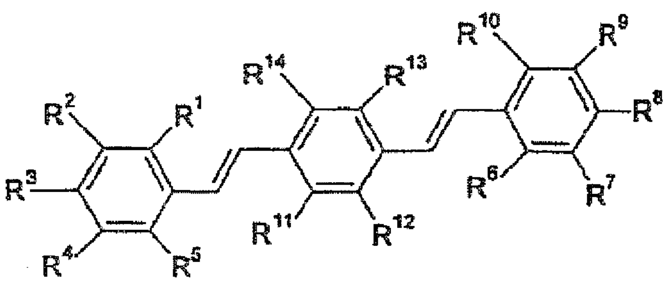

(V)

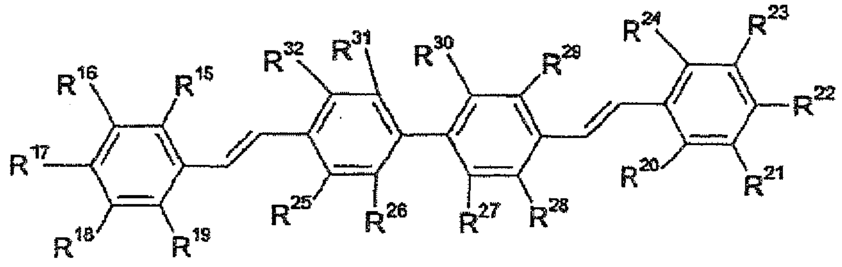

(VI)

In formula (V), $R^1$ to $R^{14}$ each independently represents a hydrogen atom, an alkyl group, an alkoxy group, a cyano group or a halogen atom, provided that at least one of $R^1$ to $R^{10}$ represents an alkoxy group having 2 or more carbon atoms.

In formula (VI), $R^{15}$ to $R^{32}$ each independently represents a hydrogen atom, an alkyl group, an alkoxy group, a cyano group or a halogen atom, provided that at least one of $R^{15}$ to $R^{24}$ represents an alkoxy group having 2 or more carbon atoms.

Specific examples of such sensitizing dye preferably used include compounds described in EP-A-1349006 and WO 2005/029187.

Next, the sensitizing dye having an absorption maximum in a wavelength range from 750 to 1,400 (hereinafter, also referred to as an "infrared absorbing agent" sometimes) suitably used in the invention is described in detail below. The infrared absorbing agent used is preferably a dye or a pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolelline cyanine dyes are particularly preferred. Further, cyanine dyes and indolenine cyanine dyes are more preferred. As particularly preferable examples of the dye, cyanine dyes represented by formula (a) shown below are exemplified.

Formula (a)

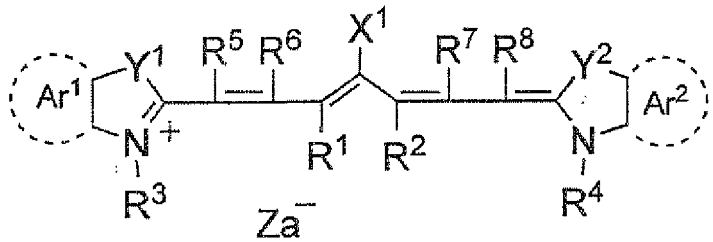

In formula (a), $X^1$ represents a hydrogen atom, a halogen atom, $-NPh_2$, $-X^2-L^1$ or a group shown below. $X^2$ represents an oxygen atom, a nitrogen atom or a sulfur atom, $L^1$ represents a hydrocarbon group having from 1 to 12 carbon atoms, an aryl group containing a hetero atom (a nitrogen atom, a sulfur atom, an oxygen atom, a halogen atom or a selenium atom) or a hydrocarbon group having from 1 to 12 carbon atoms and containing a hetero atom.

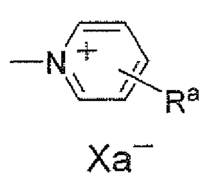

In the formula above, $Xa^-$ has the same meaning as $Za^-$ defined hereinafter. $R^a$ represents a hydrogen atom or a substituent selected from an alkyl group, an aryl group, a substituted or unsubstituted amino group and a halogen atom.

$R^1$ and $R^2$ each independently represents a hydrocarbon group having from 1 to 12 carbon atoms. In view of the preservation stability of a coating solution for photosensitive layer, it is preferred that $R^1$ and $R^2$ each represent a hydrocarbon group having two or more carbon atoms. Also, $R^1$ and $R^2$ may be combined with each other to form a ring and in case of forming the ring, to form a 5-membered or 6-membered ring is particularly preferred.

$Ar^1$ and $Ar^2$, which may be the same or different, each represents an aryl group which may have a substituent. Preferable examples of the aryl group include a benzene ring group and a naphthalene ring group. Preferable examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferable examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. From the standpoint of the availability of raw materials, a hydrogen atom is preferred. $Za^-$ represents a counter anion. However, $Za^-$ is not necessary when the cyanine dye represented by formula (a) has an anionic substituent in the structure thereof and the neutralization of charge is not needed. Preferable examples of the counter ion for $Za^-$ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a) which can be preferably used in the invention include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of.TP-A-2008-19501 8, and most preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A-2001-222101 are preferably used.

The infrared absorbing dyes may be used individually or in combination of two or more thereof and may be used together with an infrared absorbing agent other than the infrared absorbing dye, for example, a pigment. As the pigment, compounds described in Paragraph Nos. [0072] to [0076] of JP-A-2008 -195018 are preferred.

The amount of the sensitizing dye added is preferably from 0.05 to 30 parts by weight, more preferably from 0.1 to 20 parts by weight, most preferably from 0.2 to 10 parts by weight, per 100 parts by weight of the total solid content of the photosensitive layer.

(Other components for photosensitive layer)

The photosensitive layer preferably contains a chain transfer agent. The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical.

In the photosensitive layer according to the invention, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used.

The amount of the chain transfer agent added is preferably from 0.01 to 20 parts by weight, more preferably from 1 to 10 parts by weight, most preferably from 1 to 5 parts by weight, per 100 parts by weight of the total solid content of the photosensitive layer.

Into the photosensitive layer according to the invention, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a hydrophobic low molecular weight compound, for example, a higher fatty acid derivative for avoiding polymerization inhibition due to oxygen, a fine inorganic particle or fine organic particle for increasing strength of the cured layer in the image area, a hydrophilic low molecular weight compound for improving the developing property, a co-sensitizer for increasing sensitivity, and a plasticizer for improving plasticity. As the additives, known compounds, for example, compounds described in Paragraph Nos. [0161] to [0215] of JP-A-2007-206217, Paragraph No. [0067] of JP-T-2005-509192 and Paragraph Nos. [0023] to [0026] and [0059] to [0066] of JP-A-2004-310000 are used. With respect to the surfactant, surfactants which may be added to the developer described hereinafter may be used.

<Formation of photosensitive layer>

The photosensitive layer according to the invention is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer after the coating and drying on the support is preferably from 0.3 to 3.0 g/m$^2$. Various methods can be used for the coating. Examples of the method include bar coater coating, spin coating, spray coating, curtain coating, dip coating, air knife coating, blade coating and roll coating.

[Protective layer]

In the lithographic printing plate precursor according to the invention, a protective layer (oxygen-blocking layer) is provided on the photosensitive layer in order to prevent diffusion and penetration of oxygen which inhibits the polymerization reaction at the time of exposure. As a material used in the protective layer, any water-soluble polymer and water-insoluble polymer can be appropriately selected to use. The polymers may be used in combination of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Among them, a water-soluble polymer compound relatively excellent in crystallizability is preferably used. Specifically, when polyvinyl alcohol is used as a main component, the most preferred results can be obtained in the fundamental characteristics, for example, oxygen-blocking property and removability by development.

Polyvinyl alcohol for use in the protective layer may be partially substituted with an ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree from 69.0 to 100% by mole and a polymerization repeating unit number from 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). The polyvinyl alcohols can be used individually or as a mixture. According to a preferred embodiment, the content of polyvinyl alcohol in the protective layer is from 20 to 95% by weight, and more preferably from 30 to 90% by weight.

Also, known modified polyvinyl alcohol can be preferably used. Particularly, an acid-modified polyvinyl alcohol having a carboxylic acid group or a sulfuric acid group is preferably used. Specifically, modified polyvinyl alcohols described in JP-A-2005-250216 and JP-A-2006-259137 are preferably exemplified.

When the polyvinyl alcohol is used as a mixture with other material, as the other material mixed, a modified polyvinyl alcohol, polyvinyl pyrrolidone or a modified product thereof is preferred from the viewpoint of the oxygen-blocking property and removability by development. The content thereof in the protective layer is ordinarily from 3.5 to 80% by weight, preferably from 10 to 60% by weight, and more preferably from 15 to 30% by weight.

As other component of the protective layer, glycerin, dipropylene glycol or the like can be added in an amount corresponding to several % by weight of the polymer to provide flexibility. Further, an anionic surfactant, for example, sodium alkylsulfate or sodium alkylsulfonate, an amphoteric surfactant, for example, akylaminocarboxylate and alkylaminodicarboxylate, or a nonionic surfactant, for example, polyoxyethylene alkyl phenyl ether can be added in an amount of several % by weight of the polymer.

Further, it is also preferred to incorporate an inorganic stratiform compound into the protective layer of the lithographic printing plate precursor according to the invention for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful. Specifically, inorganic stratiform compounds described in JP-A-2005-119273 are preferably exemplified.

The coating amount of the protective layer is preferably in a range from 0.05 to 10 g/m$^2$ in terms of the coating amount after drying. It is more preferably in a range from 0.1 to 5 g/m$^2$, when the protective layer contains the inorganic stratiform compound, and it is more preferably in a range from 0.5 to 5 g/m$^2$, when the protective layer does not contain the inorganic stratiform compound.

[Method of preparing lithographic printing plate]

The lithographic printing plate precursor according to the invention is imagewise exposed and then subjected to development processing to prepare a lithographic printing plate. According to the invention, a method of developing with a developer having pH from 2 to 11 is used as the development processing.

In the method of preparing a lithographic printing plate according to the invention, the developing step is conducted by removing the unexposed area of the photosensitive layer and the protective layer of the lithographic printing plate precursor with a one bath (also referred to as "one bath development processing") using the developer described above. The term "one bath development processing" as used herein means that processings ordinarily necessary for the development are simultaneously conducted by one bath. Specifically, in the ordinary processing steps, a protective layer is removed in a pre-water washing, the alkali development is then conducted, the alkali is removed by washing with water in a post-water washing, and gumming treatment is conducted. On the contrary, according to the invention, the development and gumming treatment are substantially conducted simultaneously by one bath using the developer described above. Therefore, the post-water washing is not necessary, and after conducting the one bath development processing, the drying step (including natural drying) can be performed. Further, since the removal of the protective layer can be simultaneously conducted with the development processing, the pre-water washing is not necessary. After the development processing, the excess developer is preferably removed, for example, using a squeeze roller, followed by drying. The method of preparing a lithographic printing plate according to the invention is characterized in that the lithographic printing plate is prepared without undergoing a water washing step not only before the development processing but also between the development processing and a printing step. The term "printing step" as used herein means a step starting with mounting of the lithographic printing plate on a printing machine.

The development of the lithographic printing plate precursor according to the invention is performed at temperature from 0 to 60°C, preferably from about 15 to about 40°C in a conventional manner, for example, by a method wherein the imagewise exposed lithographic printing plate precursor is immersed in the developer and rubbed with a brush or a method wherein the developer is sprayed to the imagewise exposed lithographic printing plate precursor and the lithographic printing plate precursor is rubbed with a brush.

The developer for use in the invention is an aqueous solution having pH from 2 to 11. It is preferably an aqueous solution containing water as the main component (containing 60% by weight or more of water). In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is more preferably from 5 to 10.7, still more preferably From 6 to 10.5, and most preferably from 7.5 to 10.3.

The anionic surfactant for use in the developer in the invention is not particularly limited and includes, for example, fatty acid salts, abietic acid salts, hydroxyalknesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene alkylsulfonic acid salts, polyoxyethylene alkylsulfophenyl ether salts, N-alkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer in the invention is not particularly limited and hitherto known cationic surfactants may be used. For example, alkylamine salts, quaternary ammonium salts, alkylimidazolinium salts, polyoxyethylene alkyl amine salts and polyethylene polyamine derivatives are exemplified.

The nonionic surfactant for use in the developer in the invention is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred, and alkyl-substituted or unsubstituted phenol ethylene oxide adducts and alkyl-substituted or unsubstituted naphthol ethylene oxide adducts are more preferred.

The amphoteric surfactant is not particularly limited and includes, for example, amine oxide type, for example,

alkyldimethylamine oxide, betaine type, for example, alkyl betaine and amino acid type, for example, sodium salt of alkylamino fatty acid.

Particularly, an alkyldimethylamine oxide which may have a substituent, an alkyl carboxy betaine which may have a substituent and an alkyl sulfo betaine which may have a substituent are preferably used. Specific examples of the compound used include compounds represented by formula (2) in Paragraph No. [0256] of JP-A-2008-203359, compounds described in Paragraph Nos. [0028] to [0052] of JP-A-2008-276166 including compounds represented by formulae (I), (II) and (VI) in Paragraph No. [0028] of JP-A-2008-276166 and compounds described in Paragraph Nos. [0022] to [0029] of JP-A-2009-47927. Specific examples of the more preferable compound include 2-alkyl-N-carboxymethyl-N-hydroxyethyl imidazolinium betaine, alkyldiaminoethylglycine hydrochloride, lauryldimethylaminoacetic acid betaine, N-lauric acid amidopropyldimethyl betaine and N-lauric acid amidopropyldimethylamine oxide.
In particular, a nonionic surfactant represented by formulae (I-A) or (I-B) shown below is preferred.

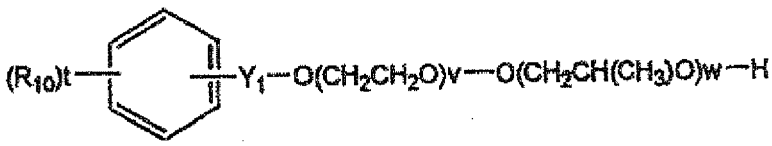

(1-A)

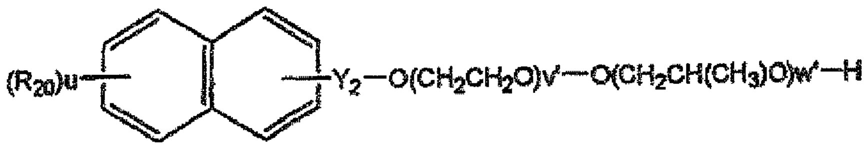

(1-B)

In formulae (I-A) and (I-B), $R_{10}$ and $R_{20}$ each independently represents a hydrogen atom or an organic group, t and u each independently represents 1 or 2, $Y_1$ and $Y_2$ each independently represents a single bond or an alkylene group (preferably an alkylene group having from 1 to 10 carbon atoms), v and w each independently represents an integer from 0 to 100, provided that v and w are not 0 at the same time and that when one of v or w is 0, the other of v and w is not 1, v' and w' each independently represents an integer from 0 to 100, provided that v' and w' are not 0 at the same time and that when one of v' and w' is 0, the other of v' and w' is not 1, when t is 2 and $R_{10}$ represents an organic group, two $R_{10}$ may be the same or different or may be combined with each other to from a ring, and when u is 2 and $R_{20}$ represents an organic group, two $R_{20}$ may be the same or different or may be combined with each other to from a ring.

v and v' is each preferably from 0 to 40, and more preferably from 2 to 20.

w and w' is each preferably from 0 to 20, and more preferably from 0 to 10.

The organic group for $R_{10}$ or $R_{20}$ preferably has from 1 to 100 carbon atoms and specifically includes a saturated or unsaturated, straight-chain or branched aliphatic hydrocarbon group or an aromatic hydrocarbon group (for example, an alkyl group, an alkenyl group, an alkynyl group, an aryl group or an aralkyl group), an alkoxy group, an aryloxy group, an N-alkylamino group, an N,N-dialkyliamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an acylamino group, an N-alkylacylamino group, an N-arylacylamino group, an acyl group, an alkoxycarbonylamino group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, a polyoxyalkylene chain, and the above-described organic groups to which a polyoxyalkylene chain is connected. The alkyl group described above may be a straight-chain or branched alkyl group.

Preferable examples of $R_{10}$ and $R_{20}$ include a hydrogen atom, a straight-chain or branched alkyl group having from 1 to 10 carbon atoms, an alkoxy group having from 1 to 10 carbon atoms. an alkoxycarbonyl group, an N-alkylamino group, an N,N-dialkylamino group, an N-alkylcarbamoyl group, an acyloxy group, an acylamino group, a polyoxyalkylene chain having a repeating unit number from about 5 to about 20, an aryl group having from 6 to 20 carbon atoms and an aryl group having a polyoxyalkylene chain having a repeating unit number from about 5 to about 20 bonded.

In the compounds represented by formulae (1-A) and (1-B), a repeating unit number of the polyoxyethylene chain is preferably from 3 to 50, and more preferably from 5 to 30. A repeating unit number of the polyoxypropylene chain is preferably from 0 to 10, and more preferably from 0 to 5. The polyoxyethylene part and polyoxypropylene part may from a random copolymer or a block copolymer.

The compound represented by formulae (1-A) includes, for example, polyoxyethylene phenyl ether, polyoxyethylene methylphenyl ether, polyoxyethylene octylphenyl ether and polyoxyethylene nonylphenyl ether.

The compound represented by formulae (1-B) includes, for example, polyoxyethylene naphthyl ether, polyoxyethylene methylnaphthyl ether, polyoxyethylene octylnaphthyl ether and polyoxyethylene nonylnaphthyl ether.

Further, from the standpoint of stable solubility in water or opacity, with respect to the nonionic surfactant used in the developer according to the invention, the HLB (hydrophile-lipophile balance) value thereof is preferably 6 or more, and more preferably 8 or more.

Moreover, an oxyethylene adduct of acetylene glycol type or acetylene alcohol type or a surfactant, for example, of fluorine-based or silicon-based can also be used.

The surfactant used in the developer according to the invention is particularly preferably a nonionic surfactant from the standpoint of antifoaming property.

As the surfactant for use in the developer according to the invention, a surfactant selected from a nonionic surfactant, an amphoteric surfactant and a combination thereof is particularly preferred.

Two or more of the surfactants may be used in combination. The content of the surfactant in the developer is preferably from 0.01 to 20% by weight, and more preferably from 0.1 to 10% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer, polyvinylsulfonic acid or a salt thereof and polystyrenesulfonic acid or a salt thereof.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

Into the developer for use in the invention, a pH buffer agent may further be incorporated.

As the pH buffer agent used in the invention, a pH buffer agent exhibiting a pH buffer function at pH from 2 to 11 is used without particular restriction. In the invention, a weak alkaline buffer agent is preferably used and includes, for example, (a) a carbonate ion and a hydrogen carbonate ion, (b) a borate ion, (c) a water-soluble amine compound and an ion of the amine compound, and a combination thereof. Specifically, for example, (a) a combination of a carbonate ion and a hydrogen carbonate ion, (b) a borate ion, or (c) a combination of a water-soluble amine compound and an ion of the amine compound exhibits a pH buffer function in the developer to prevent fluctuation of the pH even when the developer is used for a long period of time. As a result, for example, the deterioration of developing property resulting from the fluctuation of pH and the occurrence of development scum are restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

In case of adopting (a) the combination of a carbonate ion and a hydrogen carbonate ion as the pH buffer agent, the total amount of the carbonate ion and hydrogen carbonate ion is preferably from 0.05 to 5 mole/l, more preferably from 0.07 to 2 mole/l, particularly preferably from 0.1 to 1 mole/l, in the developer.

As the pH buffer agent, (c) the combination of a water-soluble amine compound and an ion of the amine compound is preferably adopted. Specifically, the developer having pH from 2 to 11 preferably contains a water-soluble amine compound and an ion of the amine compound. The water-soluble amine compound includes an alkylamine, for example, monoethanol amine, diethanol amine, triethanol amine or N-hydroxyethylmorpholine and an aromatic amine, for example, 4-dimethylaminopyridine.

The amount of the water-soluble amine compound and ion of the amine compound added is preferably from 0.5 to 20% by weight, more preferably from 1 to 15% by weight, particularly preferably from 1 to 12% by weight, in the developer.

The developer according to the invention may contain an organic solvent As the organic solvent capable of being contained, for example, an aliphatic hydrocarbon (e.g., hexane, heptane, Isopar E, Isopar H, Isopar G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone).

Two or more of the organic solvents may be used in the developer.

When the organic solvent is insoluble in water, it may be employed by being solubilized in water using a surfactant or the like. When the developer contains an organic solvent, the developer having pH from 2 to 11 preferably contains the organic solvent in an amount from 0.001 to 2.0% by weight, and the concentration of the organic solvent is desirably less than 40% by weight in view of safety and inflammability.

As the organic solvent, an organic solvent selected from the group consisting of an alcohol having from 6 to 20 carbon atoms is preferred.

The developer may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The temperature of the developer is ordinarily 60°C or lower, and preferably from about 15 to about 40°C.

The developer can be used as a developer and a development replenisher for the exposed negative type lithographic printing plate precursor. The developer can be preferably applied to an automatic processor described below. In the case of conducting the development using an automatic processor, the developer becomes fatigued in accordance with the processing amount, and hence the processing ability may be restored using a replenisher or a fresh developer.

The development processing with the developer having pH from 2 to 11 according to the invention is preferably performed by an automatic processor equipped with a supplying means for the developer and a rubbing member. An automatic development processor using a rotating brush roller as the rubbing member is particularly preferred.

Further, the automatic processor is preferably provided with a means for removing the excess developer, for example, a squeeze roller, or a drying means, for example, a hot air apparatus, subsequently to the development processing means.

In addition, in the method plate making process of preparing a lithographic printing plate from the lithographic printing plate precursor according to the invention, the lithographic printing plate precursor may be heated its entire surface before the exposure, during the exposure or between the exposure and the development, if desired. By the heating, the image-forming reaction in the photosensitive layer is accelerated and advantages, for example, improvement in the sensitivity and printing durability and stabilization of the sensitivity are achieved.

Further, for the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions and is ordinarily carried out in a temperature range from 100 to 500°C. When the temperature is too low, a sufficient effect of strengthening the image may not be obtained, whereas when it is excessively high, problems of deterioration of the support and thermal decomposition of the image area may occur sometimes.

Prior to the development processing, the lithographic printing plate precursor is, for example, exposed with laser through a transparent original having a line image, a halftone dot image or the like, or imagewise exposed by scanning of laser beam based on digital data.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in such a wavelength range is used. In case of exposing with light of 750 to 1,400 nm, the lithographic printing plate precursor containing an Infrared absorbing agent which is a sensitizing

dye having an absorption maximum in such a wavelength range is used. As the light source having a wavelength from 300 to 450 nm, a semiconductor laser is preferably used. As the light source having a wavelength from 750 to 1,400 nm, a solid laser or semiconductor laser emitting an infrared ray is preferably used. The exposure mechanism may be any of an internal drum system, an external drum system and a flat bed system.

EXAMPLES

The present invention will be described in more detail with reference to the following examples, but the invention should not be construed as being limited thereto.

Examples 1 to 22 and Comparative Examples 1 and 2

[Preparation of Lithographic printing plate precursor 1]

An aluminium plate (material: JIS A1050) having a thickness of 0.3 mm was immersed in an aqueous 10% by weight sodium hydroxide solution at 60°C for 25 seconds to effect etching, washed with running water, neutralized and cleaned with an aqueous 20% by weight nitric acid solution and then washed with water. The aluminum plate was subjected to an electrolytic surface roughening treatment in an aqueous 1 % by weight nitric acid solution using an alternating current with a sinusoidal waveform at an anode time electricity of 300 coulomb/$dm^2$. Subsequently, the aluminum plate was immersed in an aqueous 1% by weight sodium hydroxide solution at 40°C for 5 seconds, immersed in an aqueous 30% by weight sulfuric acid solution at 60°C for 40 seconds to effect a desmut treatment, and then subjected to an anodizing treatment in an aqueous 20% by weight sulfuric acid solution for 2 minutes under condition of current density of 2 A/$dm^2$ to form an anodic oxide film having a thickness of 2.7 g/$m^2$. Then, the aluminum plate was treated with an aqueous 1% by weight sodium silicate solution at 20°C for 10 seconds. The center line average roughness (Ra) of the aluminum plate was measured using a stylus having a diameter of 2 μm and found to be 0.25 μm (Ra indication according to JIS B0601).

Further, Undercoat solution (1) shown below was coated on the aluminum plate using a bar and dried in an oven at 80°C for 10 seconds to prepare a support having an undercoat layer having a dry coating amount of 15 mg/$m^2$.

<Undercoat solution (1)>

| | |
|---|---|
| Undercoat Compound (1) shown below | 0.017 g |
| Methanol | 9.00g |
| Water | 1.00g |

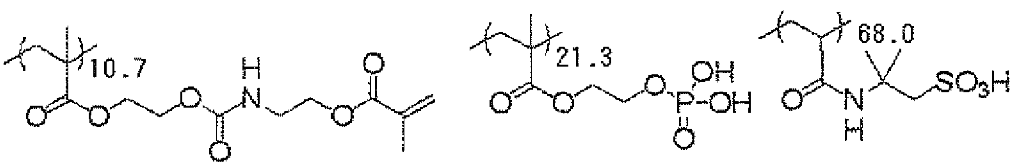

Undercoat Compound (1)

(Weight average molecular weight is 88,000, and the ratio of repeating unit is indicated in a molar ratio.)

On the aluminum support provided with the undercoat layer described above, Coating solution 1 for photosensitive layer having the composition shown below was coated using a bar and dried in an oven at 70°C for 60 seconds to form a photosensitive layer having a dry coating amount of 1.1 g/$m^2$. On the photosensitive layer, Coating solution 1 for protective layer having the composition shown below was coated using a bar so as to have a dry coating amount of 0.95 g/$m^2$ and dried at 125°C for 70 seconds to form a protective layer, thereby preparing Lithographic printing plate precursor 1.

<Coating solution 1 for photosensitive layer>

| | |
|---|---|
| Binder polymer (B-1) shown below | 0.50 g |
| Ethylenically unsaturated compound (ii) shown in Table 1 | Amount shown in Table 1 |
| Other ethylenically unsaturated compound shown in Table 1 | Amount shown in Table 1 |
| Polymerization initiator (I-1) shown below | 0.08 g |
| Sensitizing dye (D-1) shown below | 0.06 g |
| Chain transfer agent (S-1) shown below | 0.07 g |
| Dispersion of ε-phthalocyanine pigment<br>[pigment: 15 parts by weight; dispersing agent (allyl methacrylate/methacrylic acid copolymer (molar ratio: 80/20, weight average molecular weight: 60,000): 10 parts by weight; solvent: (cyclohexasone/methoxypropyl acetate/1-methoxy-2-propanol =15 parts by weight/20 parts by weight/40 parts by weight)] | 0.40 g |
| Thermal polymerization inhibitor<br>N-Nitrosophenylhydroxylamine aluminum salt | 0.01 g |
| Fluorine-based surfactant (F-1) shown below (weight average molecular weight: 10,000) | 0.001 g |
| Polyoxyethylene-polyoxypropylene condensate<br>(PLURONIC L44, produced by ADEKA Corp.) | 0.04 g |
| 1-Methoxy-2-propanol | 3.5 g |
| Methyl ethyl ketone | 8.0 g |

B−1

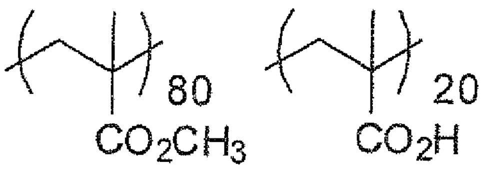

Mw = 50,000

D−1

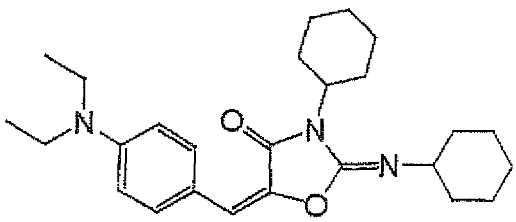

I－1

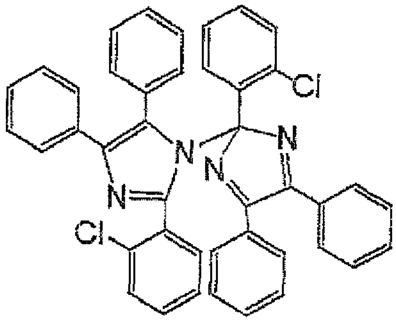

S－1

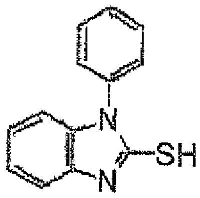

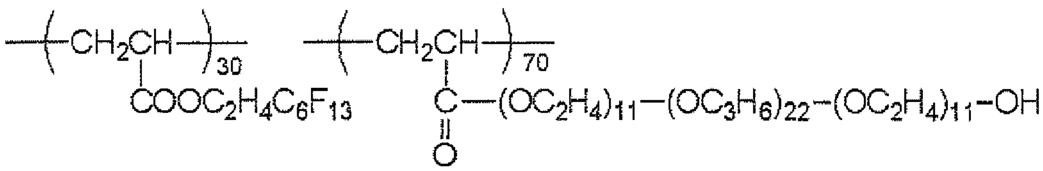

F－1

<Coating solution 1 for protective layer>

| | |
|---|---|
| Polyvinyl alcohol (PVA-105, produced by Kuraray Co., Ltd., (saponification degree: 98% by mole, polymerization degree: 500) | 40 g |
| Polyvinyl pyrrolidone (weight average molecular weight: 50,000) | 5 g |
| Vinyl pyrrolidone/vinyl acetate (1/1) copolymer (weight average molecular weight: 70,000) | 0.5 g |
| Surfactant (EMALEX 710, produced by Nihon-Emulsion Co., Ltd.) | 0.5 g |
| Water | 950 g |

[Exposure, Development and Printing]

The lithographic printing plate precursor was subjected to image exposure by Violet semiconductor laser plate setter Vx9600 (equipped with InGaN semiconductor laser; emission: 405 nm ± 10 nm/output: 30 mW) produced by FUJIFILM Electronic Imaging, Ltd. The image drawing was conducted at a resolution of 2,438 dpi with halftone dots of 50% using an FM screen (TAFFETA 20, produced by FUJIFILM Corp.) under condition of a plate surface exposure amount of 0.05 mJ/cm$^2$.

The exposed lithographic printing plate precursor was then subjected to development processing in an automatic development processor having the structure shown in Fig. 1 using Developer 1 having the composition shown below. A heater was set so as to reach the plate surface temperature at 100°C in the pre-heating unit and the development

processing was conducted at a transporting speed so as to make the immersion time (developing time) in the developer for 20 seconds.

The automatic development processor 100 shown in Fig. comprises a chamber the outer shape of which is formed by a machine casing 202 and has a pre-heating unit 200, a developing unit 300 and a drying unit 400 continuously formed along a transporting direction (arrow A) of a transporting pass 11 for a lithographic printing plate precursor.

The pre-heating unit 200 comprises a heating chamber 208 having a transporting inlet 212 and a transporting outlet 218 and a skewer roller 210, a heater 214 and a circulation fan 216 are arranged in the inside thereof.

The developing unit 300 is separated from the pre-heating unit 200 by an outer panel 310 and a slit type insertion slot 312 is formed in the outer panel 310.

In the inside of the developing unit 300, a processing tank 306 having a developing tank 308 filled with a developer and an insertion roller pair 304 for guiding the lithographic printing plate precursor into the inside of the processing tank 306 are disposed. A shielding cover 324 is located above the developing tank 308.

In the inside of the developing tank 308, a guide roller 344 and a guide member 342, a submerged roller pair 316, a brush roller pair 322, a brush roller pair 326 and a carrying-out roller pair 318 are provided in order from the upstream side of the transporting direction of lithographic printing plate precursor. The lithographic printing plate precursor transported into the developing tank 308 is immersed in the developer and the non-image area is removed by passing between the rotating brush roller pairs 322 and 326.

A spray pipe 330 is provided under the brush roller pairs 322 and 326. The spray pipe 330 is connected to a pump (not shown) and the developer in the developing tank 308 sucked by the pump is ejected from the spray pipe 330 in the developing tank 308.

On a sidewall of the developing tank 308, an overflow aperture 51 is provided to form a top edge of a first circulation pipeline C1. The excess developer flows in the overflow aperture 51, passes through the first circulation pipeline C1 and is discharged in an external tank 50 provided outside the developing unit 300.

To the external tank 50 is connected a second circulation pipeline C2 and a filter unit 54 and a developer supply pump 55 are located in the second circulation pipeline C2. The developer is supplied from external tank 50 to the developing tank 308 by the developer supply pump 55. In the external tank 50, an upper limit liquid level meter 52 and a lower limit liquid level meter 53 are provided.

The developing tank 308 is also connected to a water tank for replenishment 71 through a third circulation pipeline C3. A water-replenishing pump 72 is located in the third circulation pipeline C3 and water pooled in the water tank for replenishment 71 is supplied to the developing bath 308 by the water-replenishing pump 72.

A liquid temperature sensor 336 is provided on the upstream side of the submerged roller pair 316. A liquid level meter 338 is provided on the upstream side of the carrying-out roller pair 318.

In a partition board 332 placed between the developing unit 300 and the drying unit 400, a slit type pass-through slot 334 is formed. Also, a shutter (not shown) is provided along a passage between the developing unit 300 and the drying unit 400 and the passage is closed by the shutter when the lithographic printing plate precursor does not pass through the passage.

In the drying unit 400, a support roller 402, ducts 410 and 412, a transport roller pair 406, ducts 410 and 412 and a transport roller pair 408 are disposed in this order. A slit hole 414 is provided at the top of each of the ducts 410 and 412. In the drying unit 400, a drying means (not shown), for example, a hot air supplying means or a heat generating means, is also provided. The drying unit 400 has a discharge slot 404 and the resulting lithographic printing plate dried by the drying means is discharged through the discharge slot 404.

The automatic development processor used in the example had two rotating brush rollers each having an outer diameter of 50 mm and being implanted with fiber of polybutylene terephthalate (bristle diameter: 200 μm, bristle length: 17 mm) and being rotated in the same direction as the transporting direction of the lithographic printing plate precursor. The temperature of the developer was 30°C. After the development processing, drying was conducted in the drying unit. The drying temperature was 80°C.

<Developer 1>

| | |
|---|---|
| Surfactant-1 (SOFTAZOLINE LPB-R, produced by Kawaken Fine Chemicals Co., Ltd.) | 15 g |
| Surfactant-2 (SOFTAZOLINE LAO, produced by Kawaken Fine Chemicals Co., Ltd.) | 4 g |
| 1-Phenoxy-2-propanol | 4 g |
| 1-Octanol | 3 g |

(continued)

| | |
|---|---|
| Chelating agent: Trisodium ethylenediaminesuccinate (OCTAQUEST E30, produced by Innospec Specialty Chemicals Inc.) | 0.68 g |
| 2-Bromo-2-nitropropane-1,3-diol | 0.025 g |
| 2-Methyl-4-isothiazoline-3-one | 0.025 g |
| Silicone type deforming agent: (TSA 739, produced by GE Toshiba Silicone Co., Ltd.) | 0.15 g |
| Sodium gluconate | 1.5 g |
| Sodium carbonate | 1.06 g |
| Sodium hydrogen carbonate | 0.52 g |
| Water | 77.04 g |

The pH was adjusted to 9.80 by adding sodium hydroxide and phosphoric acid.

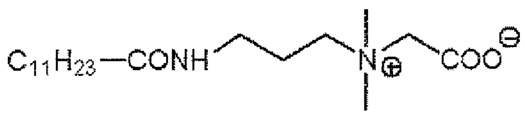

SOFTAZOLINE LPB-R

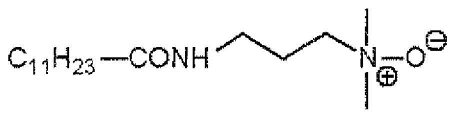

SOFTAZOLINE LAO

The lithographic printing plate obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

[Evaluation]

With respect to the lithographic printing plate precursors described above, the developing property, sensitivity, printing durability, ink-receptive property, processing property and reproducibility of halftone dot were evaluated in the manner shown below. The results obtained are shown in Table 1.

<Developing property>

With the lithographic printing plates obtained by performing the development processing while varying the transporting speed, cyan density of the non-image area was measured by a Macbeth densitometer. The transporting speed at which the cyan density of the non-image area became equivalent to cyan density of the aluminum support was determined to evaluate the developing property. The evaluation of developing property was indicated by a relative developing property as defined below using Comparative Examples 1 as the criterion (1.0). When the value of the relative developing property is larger, it is meant that the developing property is higher and the performance is better.

Relative developing property = (Transporting speed of subject lithographic printing plate precursor)/(Transporting speed of criterion lithographic printing plate precursor)

<Sensitivity>

After performing printing of 100 sheets under the conditions described above and confirming that a printed material free from ink stain in the non-image area was obtained, 500 sheets were continuously printed. The exposure amount for causing no unevenness in the ink density of the image area on the 600th printed material was determined as the sensitivity. The evaluation of sensitivity was indicated by a relative sensitivity as defined below using Comparative Example 1 as the criterion (1.0). When the value of the relative sensitivity is larger, it is meant that the sensitivity is higher and the performance is better.

Relative sensitivity = (Exposure amount of criterion lithographic printing plate precursor)/(Exposure amount of subject lithographic printing plate precursor)

<Printing durability>

As increase in the number of printing sheets, the photosensitive layer was gradually abraded to cause decrease in the ink receptivity, resulting in decrease of ink density on printing paper. With respect to the lithographic printing plate obtained by the exposure in the same exposure amount (90 $\mu J/cm^2$), a number of printed materials obtained until the ink density (reflection density) decreased by 0.1 from that at the initiation of printing was determined to evaluate the printing durability. The evaluation of printing durability was indicated by a relative printing durability as defined below using Comparative Example 1 as the criterion (1.0). When the value of the relative printing durability is larger, it is meant that the printing durability is higher.

Relative printing durability = (Printing durability of subject lithographic printing plate precursor)/(Printing durability of criterion lithographic printing plate precursor)

<Ink-receptive property>

The lithographic printing plate was subjected to the printing as described above. On the 100th printed material, the ink density in the image area was evaluated according to the criteria described below.

A: Unevenness of the ink density in the image area was not present.
B: Slight unevenness of the ink density in the image area was present.
C: Considerable unevenness of the ink density in the image area was present or the image was not obtained because ink did not attach.

<Processing property>

After the lithographic printing plate precursor was subjected to development processing using the automatic development processor as described above in an amount of 500 $m^2$, the generation of scum. adhered on the tank wall of the automatic development processor was observed and evaluated according to the criteria described below.

A: The generation of scum was not observed.
B: The generation of scum was slightly observed.
C: The generation of scum was observed, but was in an acceptable level.
D: The generation of scum was severe.

<Reproducibility of halftone dot>

After performing printing of 1,000 sheets under the conditions described above, the change of an area of 50% halftone dot was determined before and after the printing and evaluated according to the criteria described below.
A: The change of area of 50% halftone dot was less than 1%.
B: The change of area of 50% halftone dot was from 1% to less than 2%.
C: The change of area of 50% halftone dot was from 2% to less than 3%.
D: The change of area of 50% halftone dot was 3% or more.

TABLE 1

| | Ethylenically Unsaturated Compound (ii) | Other Ethylenically Unsaturated Compound | Developing Property | Sensitivity | Printing Durability | Ink-Receptive Property | Processing Property | Reproducibility of Halftone Dot |
|---|---|---|---|---|---|---|---|---|
| Example 1 | M-14(0.90g) | None | 1.0 | 1.0 | 0.8 | A | C | C |
| Example 2 | M-15(0.90g) | None | 1.2 | 0.9 | 0.8 | A | B | C |
| Example 3 | M-17 (0.90 g) | None | 1.5 | 0.8 | 0.7 | A | B | C |
| Example 4 | M-18 (0.90 g) | None | 1.7 | 0.7 | 0.7 | A | B | C |
| Example 5 | M-9 (0.90g) | None | 1.1 | 1.0 | 1.0 | A | C | B |
| Example 6 | M-10 (0.90 g) | None | 1.2 | 0.9 | 1.0 | A | B | B |
| Example 7 | M-11 (0.90 g) | None | 1.5 | 0.8 | 1.0 | A | B | B |
| Example 8 | M-19 (0.90 g) | None | 1.1 | 1.0 | 1.2 | A | B | B |
| Example 9 | M-20 (0.90 g) | None | 1.3 | 1.0 | 1.2 | A | B | B |
| Example 10 | M-56 (0.90 g) | None | 0.9 | 1.0 | 1.0 | A | B | B |
| Example 11 | M-59 (0.90 g) | None | 1.0 | 1.0 | 1.0 | A | B | B |
| Example 12 | M-66 (0.90 g) | None | 1.0 | 1.0 | 1.1 | A | B | B |
| Example 13 | M-67 (0.90 g) | None | 0.9 | 1.0 | 1.2 | A | C | B |
| Example 14 | M-68 (0.90 g) | None | 1.0 | 1.0 | 1.2 | A | B | B |
| Example 15 | M-69 (0.90 g) | None | 1.1 | 1.0 | 1.0 | A | B | B |
| Example 16 | M-18 (0.40 g) | M-1 (0.50 g) | 1.1 | 0.9 | 0.9 | A | B | C |
| Example 17 | M-18(0.70g) | M-2 (0.20 g) | 1.1 | 0.9 | 0.8 | A | B | C |
| Example 18 | M-18 (0.40 g) | M-2 (0.50 g) | 1.0 | 0.9 | 1.2 | A | B | B |
| Example 19 | M-18 (0.20 g) | M-2 (0.70 g) | 0.9 | 1.0 | 1.3 | A | C | B |
| Example 20 | M-18 (0.40 g) | M-3 (0.50 g) | 1.0 | 1.0 | 1.1 | A | B | B |
| Example 21 | M-11 (0.40 g) | M-2 (0.50 g) | 1.1 | 1.0 | 1.1 | A | B | B |
| Example 22 | M-20 (0.40 g) | M-2 (0.50 g) | 1.1 | 1.0 | 1.1 | A | B | B |
| Comparative | None | M-1 (0.90g) | 1.0 | 1.0 | 1.0 | A | D | C |

(continued)

| | Ethylenically Unsaturated Compound (ii) | Other Ethylenically Unsaturated Compound | Developing Property | Sensitivity | Printing Durability | Ink-Receptive Property | Processing Property | Reproducibility of Halftone Dot |
|---|---|---|---|---|---|---|---|---|
| Example 1 | | | | | | | | |
| Comparative Example 2 | None | M-2 (0.90 g) | 0.9 | 1.1 | 1.1 | A | D | C |

As shown in Table 1, it can be seen that the processing property is dramatically improved by using the ethylenically unsaturated compound (ii) having a hydrophilic group according to the invention. Also, as shown in Examples 5 to 9 and 12 to 15, it can be seen that not only the printing durability but also the reproducibility of halftone dot are further improved in case of using the ethylenically unsaturated compound having a hydrophilic group and a photooxidizable group. The further improvement in the reproducibility of halftone dot is an unexpected result. Further, as shown in Examples 16 to 22, the similar result is observed when the ethylenically unsaturated compound having a photooxidizable group is separately added.

Examples 23 to 47 and Comparative Examples 3 to 6

[Preparation of Lithographic printing plate precursor 2]

(Preparation of Support 2)

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The aluminum plate degreased was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 $A/dm^2$ in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate subjected to the desmut treatment was subjected to an anodizing treatment under conditions of current density of 10 $A/dm^2$ and voltage of 15 V in an aqueous 15% by weight sulfuric acid solution at 25°C for one minute and to a hydrophilizing treatment using an aqueous 1% by weight polyvinylphosphonic acid solution at 75°C to prepare Support 2. The surface roughness of the support was measured and found to be 0.44 μm (Ra indication according to JIS B0601).

(Formation of Photosensitive layer 2)

Coating solution (2) for photosensitive layer having the composition shown below was coated on Support 2 described above using a bar and dried in an oven at 90°C for 60 seconds to form Photosensitive layer 2 having a dry coating amount of 1.3 $g/m^2$.

<Coating solution (2) for photosensitive layer>

| | |
|---|---|
| Binder polymer (1) shown below (weight average molecular weight: 50,000) | Amount shown in Table 2 |
| Binder polymer (2) shown below (weight average molecular weight: 80,000) | Amount shown in Table 2 |
| Ethylenically unsaturated compound (ii) shown in Table 2 | Amount shown in Table 2 |
| Other ethylenically unsaturated compound shown in Table 2 | Amount shown in Table 2 |
| Sensitizing dye (1) shown below | 0.03 g |
| Sensitizing dye (2) shown below | 0.015 g |
| Sensitizing dye (3) shown below | 0.015 g |
| Polymerization initiator (I-1) shown above | 0.13 g |
| Chain transfer agent Mercaptobenzothiazole | 0.01 g |
| Dispersion of ε-phtalocyanine pigment (pigment: 15 parts by weight; dispersing agent (allyl methacrylate/methacrylic acid copolymer (copolymerization molar ratio: 83/17, weight average molecular weight: 60,000)): 10 parts by weight; cyclohexanone: 15 parts by weight) | 0.40 g |

(continued)

| | |
|---|---|
| Thermal polymerization inhibitor<br>N-Nitrosophenylhydroxylamine aluminum salt | 0.01g |
| Fluorine-based surfactant (F-1) shown above (weight average molecular weight: 10,000) | 0.001 g |
| 1-Methoxy-2-propanol | 3.5 g |
| Methyl ethyl ketone | 8.0 g |

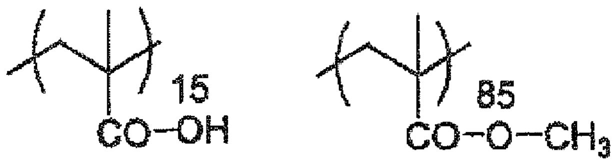

Binder polymer (1) (Acid value: 85 mg-KOH/g)

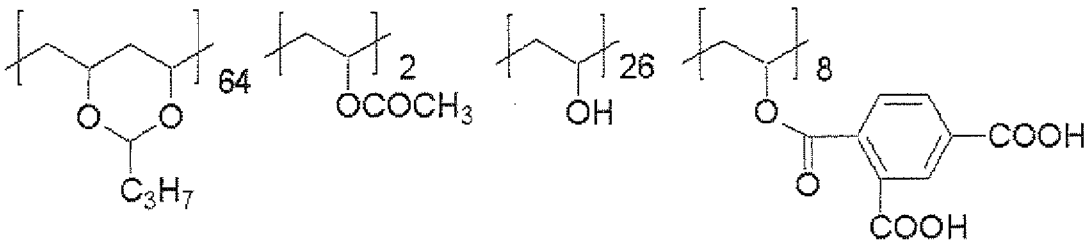

Binder polymer (2) (Acid value: 66 mg-KOH/g)

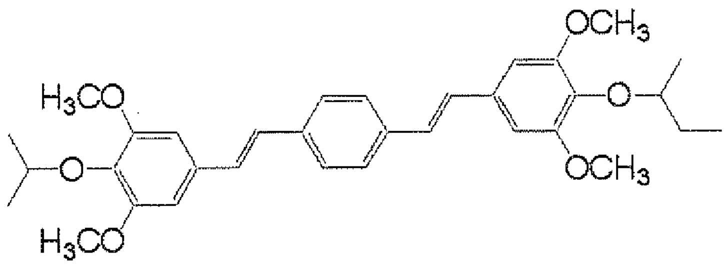

Sensitizing dye (1)

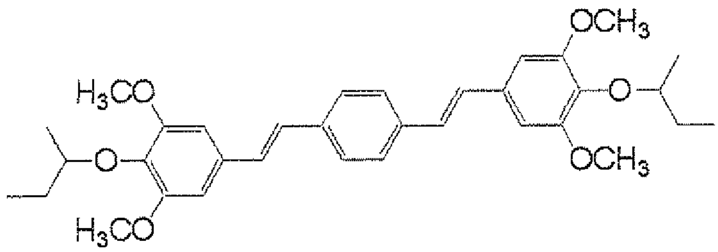

Sensitizing dye (2)

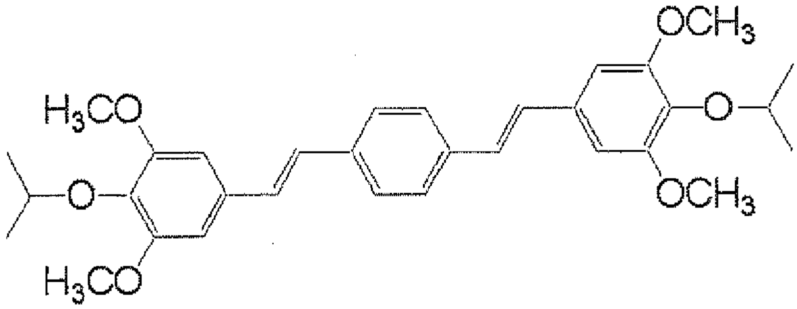

Sensitizing dye (3)

(Formation of Protective layer 2)

Coating solution (2) for protective layer having the composition shown below was coated on Photosensitive layer 2 described above using a bar so as to have a dry coating amount of 1.2 g/m$^2$ and dried at 125°C for 70 seconds to form Protective layer 2, thereby preparing Lithographic printing plate precursor 2.

<Coating solution (2) for protective layer>

| | |
|---|---|
| PVA-205 (partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C)) | 0.658 g |
| PVA-105 (fully hydrolyzed polyvinyl alcohol, produced by Kuraray Co., Ltd. (saponification degree: 98.0 to 99.0% by mole; viscosity: 5.2 to 6.0 mPa·s in a 4% by weight aqueous solution at 20°C)) | 0.142 g |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

[Exposure, Development and Printing]

The lithographic printing plate precursor was subjected to image exposure by Violet semiconductor laser plate setter Vx9600 (equipped with InGaN semiconductor laser; emission: 405 nm± 10 nm/output: 30 mW) produced by FUJIFILM Electronic Imaging, Ltd. The image drawing was conducted at a resolution of 2,438 dpi with halftone dots of 50% using an FM screen (TAFFETA 20, produced by FUJIFILM Corp.) under condition of a plate surface exposure amount of 0.05 mJ/cm$^2$.

The exposed lithographic printing plate precursor was then subjected to development processing in an automatic development processor having the structure shown in Fig. 1 using Developer 2 having the composition shown below. A heater was set so as to reach the plate surface temperature at 100°C in the pre-heating unit and the development processing was conducted at a transporting speed so as to make the immersion time (developing time) in the developer for 20 seconds.

The lithographic printing plate obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

<Developer 2>

| | |
|---|---|
| Water | 88.6 g |
| Nonionic Surfactant (W-1) shown below | 2.4 g |
| Nonionic Surfactant (W-2) shown below | 2.4 g |
| Nonionic Surfactant (EMALEX 710, produced by Nihon Emulsion Co., Ltd.) | 1.0 g |
| Phenoxypropanol | 1.0 g |
| Octanol | 0.6 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (VERSA TL77 (30% by weight solution), produced by Alco Chemical Inc.) | 1.0 g |

The pH was adjusted to 7.0 by adding phosphoric acid.

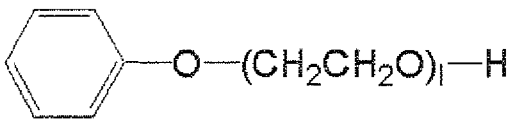

l=13-28

(W-1)

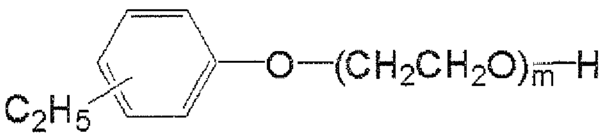

m=12-26

(W-2)

[Evaluation]

With respect to the lithographic printing plate precursors described above, the developing property, sensitivity, printing durability, ink-receptive property, processing property and reproducibility of halftone dot were evaluated in the manner as in Example 1. The results obtained are shown in Table 2. The evaluations of developing property, sensitivity and printing durability were indicated by the relative printing durability, sensitivity and printing durability as defined above using Comparative Example 3 as the criterion (1.0), respectively.

TABLE 2

| | Ethylenically Unsaturated Compound (ii) | Other Ethylenically Unsaturated Compound | Binder Polymer | Developing Property | Sensitivity | Printing Durability | Ink-Receptive Property | Processing Property | Reproducibility of Halftone Dot |
|---|---|---|---|---|---|---|---|---|---|
| Example 23 | M-15(0.90) | None | (1) (0.34 g) | 1.0 | 1.0 | 0.7 | A | B | C |
| Example 24 | M-15(0.90) | None | (2) (0.34 g) | 1.0 | 1.1 | 0.8 | A | B | B |
| Example 25 | M-15(0.90) | None | (1)(0.04g)+ (2) (0.30 g) | 1.2 | 0.9 | 0.9 | A | B | A |
| Example 26 | M-14(0.90) | None | (1)(0.04g)+ (2) (0.30 g) | 1.0 | 1.0 | 1.0 | A | C | B |
| Example 27 | M-17(0.90) | None | (1)(0.04g)+ (2) (0.30 g) | 1.5 | 0.9 | 0.8 | A | B | A |
| Example 28 | M-18 (0.90) | None | (1)(0.04g)+ (2) (0.30g) | 1.7 | 0.8 | 0.8 | A | B | A |
| Example 29 | M-12(0.90) | None | (1)(0.04g)+ (2) (0.30 g) | 1.0 | 1.1 | 1.1 | A | C | A |
| Example 30 | M-13 (0.90) | None | (1)(0.34g) | 1.1 | 1.0 | 0.9 | A | B | C |
| Example 31 | M-13(0.90) | None | (2)(0.34g) | 1.0 | 1.1 | 1.0 | A | B | B |
| Example 32 | M-13(0.90) | None | (1)(0.04g) + (2) (0.30 g) | 1.1 | 1.0 | 1.1 | A | B | A |
| Example 33 | M-21 (0.90) | None | (1)(0,04g)+ (2) (0.30 g) | 1.1 | 1.0 | 1.2 | A | B | A |
| Example 34 | M-22 (0.90) | None | (1)(0.04g)+ (2)(0.30g) | 1.3 | 1.0 | 1.2 | A | B | A |
| Example 35 | M-54(0.90) | None | (1)(0.04g)+ (2)(0.30g) | 1.0 | 1.0 | 1.0 | A | B | A |
| Example 36 | M-57(0.90) | None | (1)(0.04g)+ (2) (0.30 g) | 1.1 | 1.0 | 1.0 | A | B | A |
| Example 37 | M-64(0.90) | None | (1)(0.04g)+ | 0.9 | 1.1 | 1.1 | A | B | A |

(continued)

| | Ethylenically Unsaturated Compound (ii) | Other Ethylenically Unsaturated Compound | Binder Polymer | Developing Property | Sensitivity | Printing Durability | Ink-Receptive Property | Processing Property | Reproducibility of Halftone Dot |
|---|---|---|---|---|---|---|---|---|---|
| | | | (2)(0.30g) | | | | | | |
| Example 38 | M-65 (0.90) | None | (1) (0.04g) + (2) (0.30g) | 0.8 | 1.1 | 1.2 | A | C | A |
| Example 39 | M-18(0.40) | M-1 (0.50g) | (1) (0.04g) + (2) (0.30g) | 1.1 | 0.9 | 0.9 | A | B | B |
| Example 40 | M-18 (0.70) | M-2 (0.20 g) | (1)(0.04g)+ (2) (0.30g) | 1.1 | 0.9 | 0.8 | A | B | B |
| Example 41 | M-18(0.40) | M-2 (0.50 g) | (1) (0.34 g) | 1.0 | 1.0 | 0.9 | A | B | C |
| Example 42 | M-18(0.40) | M-2(0.50g) | (2) (0.34 g) | 1.0 | 1.0 | 1.0 | A | B | B |
| Example 43 | M-18(0.40) | M-2 (0.50 g) | (1) (0.04g)+ (2) (0.30g) | 1.0 | 1.0 | 1.1 | A | B | A |
| Example 44 | M-18 (0.20) | M-2 (0.70 g) | (1)(0.04g)+ (2) (0.30 g) | 0.9 | 1.0 | 1.3 | A | C | A |
| Example 45 | M.18(0.40) | M-2(0.50g) | (1)(0.04g)+ (2) (0.30 g) | 1.1 | 1.0 | 1.1 | A | B | A |
| Example 46 | M-11 (0.40) | M-2(0.50g) | (1) (0.04 g) + (2)(0.30g) | 1.1 | 1.0 | 1.1 | A | B | A |
| Example 47 | M-22(0.40) | M-2(0.50g) | (1)(0.04g)+ (2) (0.30g) | 1.0 | 1.1 | 1.1 | A | B | A |
| Comparative Example 3 | None | M-1 (0.90g) | (1)(0.34g) | 1.0 | 1.0 | 1.0 | A | D | C |
| Comparative Example 4 | None | M-1 (0.90 g) | (2) (0.34g) | 1.0 | 1.0 | 1.0 | A | D | C |
| Comparative Example 5 | None | M-1 (0.90 g) | (1)(0.04g) + (2) (0.30 g) | 1.0 | 1.0 | 1.0 | A | D | C |
| Comparative | None | M-2 (0.90 g) | (1)(0.04g)+ | 0.9 | 1.1 | 1.1 | A | D | C |

(continued)

| | Ethylenically Unsaturated Compound (ii) | Other Ethylenically Unsaturated Compound | Binder Polymer | Developing Property | Sensitivity | Printing Durability | Ink-Receptive Property | Processing Property | Reproducibility of Halftone Dot |
|---|---|---|---|---|---|---|---|---|---|
| Example 6 | | | (2) (0.30g) | | | | | | |

As shown in Table 2, it can also be seen in the combination of Photosensitive layer 2 with Developer 2 that the processing property is dramatically improved by using the ethylenically unsaturated compound (ii) having a hydrophilic group according to the invention. Similar to the results shown in Table 1, it can be seen that not only the printing durability but also the reproducibility of halftone dot are further improved in case of using the ethylenically unsaturated compound having a hydrophilic group and a photo-oxidizable group. Further, the similar result is observed when the ethylenically unsaturated compound having a hydrophilic group and the ethylenically unsaturated compound having a photo-oxidizable group are separately added.

Examples 48 to 71 and Comparative Examples 7 and 8

[Preparation of Lithographic printing plate precursor 2]

(Preparation of Support)

The support was prepared in the same manner as in Example 1.

(Formation of photosensitive layer)

Coating solution 3 for photosensitive layer shown below was prepared and coated on the support prepared above using a wire bar. Drying was conducted by a hot air drying apparatus at 100°C for 60 seconds. The coverage of the photosensitive layer after drying was 1.4 g/$m^2$.

<Coating solution 3 for photosensitive layer>

| | | |
|---|---|---|
| Infrared absorbing agent (IR-1) shown below | | 0.030 g |
| Polymerization initiator A (I-2) shown below | | 0.069 g |
| Polymerization initiator B (I-3) shown below | | 0.094 g |
| Chain transfer agent (S-1) shown below | | 0.020 g |
| Ethylenically unsaturated compound (ii) having hydrophilic group shown in Table 3 | Amount shown in Table 3 | |
| Other ethylenically unsaturated compound shown in Table 3 | Amount shown in Table 3 | |
| Binder polymer A (B-3) (weight average molecular weight: 110,000) shown below | | 0.250 g |
| Binder polymer B (B-4) (weight average molecular weight: 100,000) shown below | | 0.200 g |
| Binder polymer C (B-5) (weight average molecular weight: 120,000) shown below | | 0.150 g |
| Additive (T-1) shown below | | 0.080 g |
| Polymerization inhibitor (Q-1) shown below | | 0.0012 g |
| Ethyl violet (EV-1) shown below | | 0.021 g |
| Fluorine-based surfactant | | 0.0081 g |
| | (MEGAFAC F-780-F, produced by Dainippon Ink & Chemicals Inc., 30% by weight methyl isobutyl ketone (MIBK) solution) | |

(continued)

| | |
|---|---|
| Methyl ethyl ketone | 5.886 g |
| Methanol | 2.733 g |
| 1-Methoxy-2-propanol | 5.886 g |

The structures of Infrared absorbing agent (IR-1), Polymerization initiator A (I-2), Polymerization initiator B (I-3), Binder polymer A (B-3), Binder polymer B (B-4), Binder polymer C (B-5), Additive (T-1), Polymerization inhibitor (Q-1) and Ethyl violet (EV-1) used in Coating solution 3 for photosensitive layer are shown below, respectively.

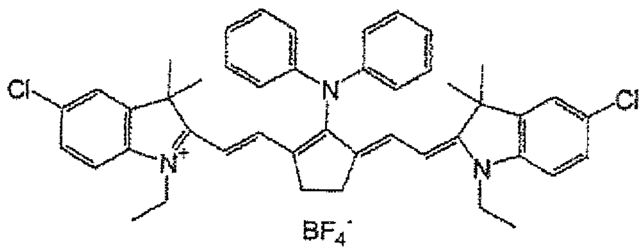

(IR-1)

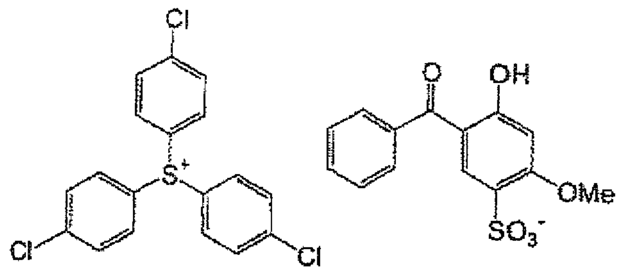

(I-2)

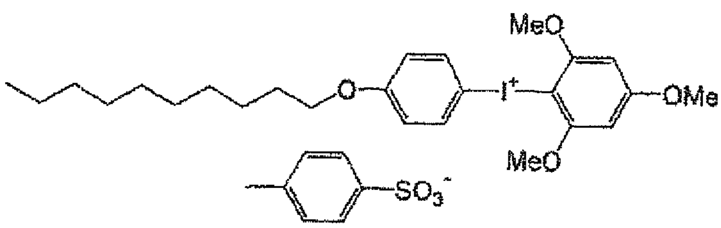

(I-3)

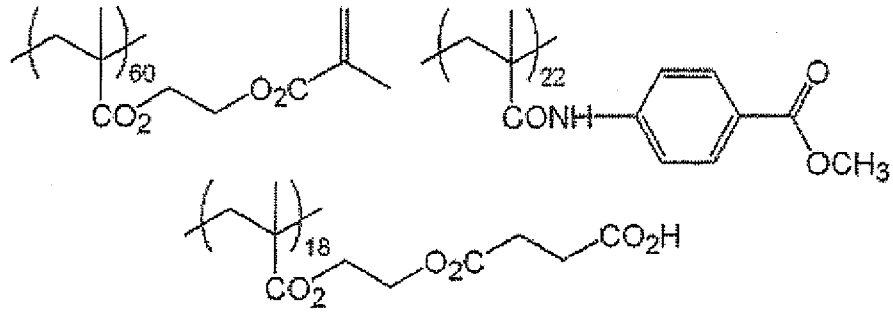

(B−3)

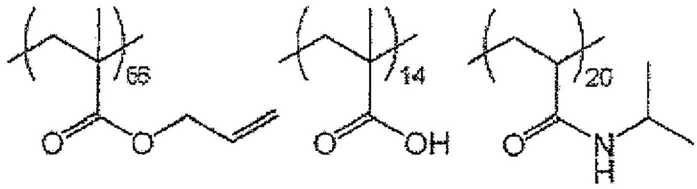

(B−4)

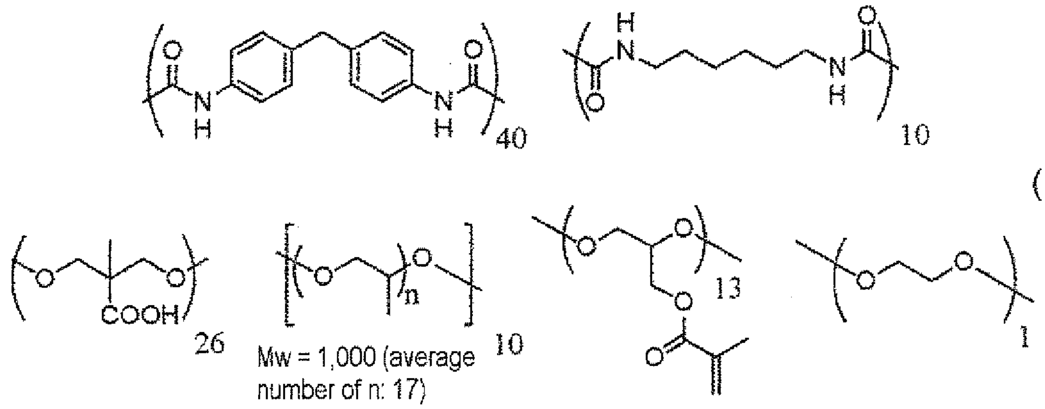

Mw = 1,000 (average number of n: 17)

(B - 5)

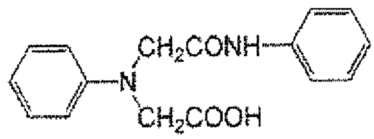

(T−1)

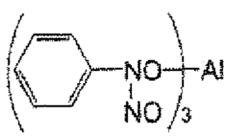

(Q−1)

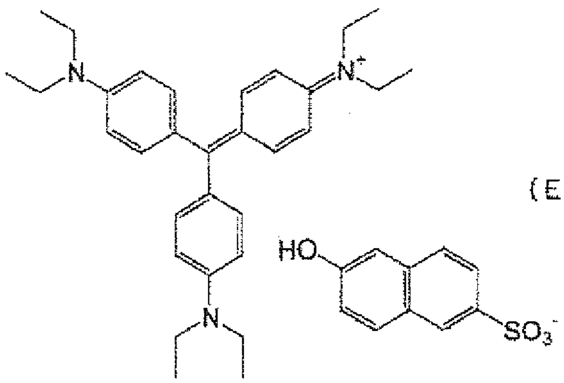

(EV-1)

(Formation of Protective layer)

The protective layer was formed in the same manner as in Example 1.

[Exposure, Development and Printing]

The lithographic printing plate precursor thus-prepared was treated according to the steps of exposure, development processing and drying as shown below.

Specifically, the lithographic printing plate precursor was imagewise exposed by TRENDSETTER 3244VX (produced by Creo Co.) equipped with a water-cooled 40 W infrared semiconductor laser under the conditions of output of 9 W, a rotational number of an external drum of 210 rpm, resolution of 2,400 dpi and a halftone dot area ratio of 50%. Within 30 seconds, the exposed lithographic printing plate precursor was pre-heated at 100°C for 30 minutes and then subjected to the development processing by the automatic development processor having the structure shown in Fig. 1 using Developer 1 described above in the same manner as in Example 1.

The lithographic printing plate obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

[Evaluation]

With respect to the lithographic printing plate precursors described above, the developing property, sensitivity, printing durability, ink-receptive property, processing property and reproducibility of halftone dot were evaluated in the manner as in Example 1. The evaluations of developing property, sensitivity and printing durability were indicated by the relative printing durability, sensitivity and printing durability as defined above using Comparative Example 7 as the criterion (1.0).

TABLE3

| | Ethylenically Unsaturated Compound (ii) | Other Ethylenically Unsaturated Compound | Developing Property | Sensitivity | Printing Durability | Ink-Receptive Property | Processing Property | Reproducibility of Halftone Dot |
|---|---|---|---|---|---|---|---|---|
| Example 48 | M-23 (0.90 g) | None | 0.9 | 1.0 | 0.8 | A | C | C |
| Example 49 | M-24 (0.90 g) | None | 1.1 | 0.9 | 0.8 | A | B | C |
| Example 50 | M-26(0.90g) | None | 1.4 | 0.8 | 0.7 | A | B | C |
| Example 51 | M-27 (0.90 g) | None | 1.6 | 0.7 | 0.7 | A | B | C |
| Example 52 | M-32(0.90g) | None | 1.1 | 1.0 | 1.1 | A | C | B |
| Example 53 | M-33 (0.90 g) | None | 1.2 | 0.9 | 1.0 | A | B | B |
| Example 54 | M-34(0.90g) | None | 1.5 | 0.8 | 0.9 | A | B | B |
| Example 55 | M-35(0.90g) | None | 1.2 | 0.9 | 1.3 | A | B | B |
| Example 56 | M-36 (0.90 g) | None | 1.3 | 0.9 | 1.2 | A | B | B |
| Example 57 | M-30(0.90g) | None | 1.1 | 1.0 | 1.1 | A | B | B |
| Example 58 | M-31 (0-90g) | None | 1.3 | 1.0 | 1.1 | A | B | B |
| Example 59 | M-56 (0.90g) | None | 0.9 | 1.1 | 1.1 | A | B | B |
| Example 60 | M-59 (0.90g) | None | 1.0 | 1.1 | 1.0 | A | B | B |
| Example 61 | M-66 (0.90g) | None | 0.9 | 1.0 | 1.1 | A | B | B |
| Example 62 | M-67 (0.90g) | None | 0.8 | 1.1 | 1.2 | A | C | B |
| Example 63 | M-68 (0.90g) | None | 0.9 | 1.0 | 1.2 | A | B | B |
| Example 64 | M-69 (0.90 g) | None | 1.0 | 1.0 | 1.0 | A | B | B |
| Example 65 | M-26 (0.40 g) | M-5(0.50g) | 1.0 | 0.9 | 0.9 | A | B | C |
| Example 66 | M-26(0.70g) | M-6 (0.20 g) | 1.0 | 0.9 | 0.8 | A | B | C |
| Example 67 | M-26 (0.40 g) | M-6 (0.50g) | 0.9 | 0.9 | 1.2 | A | B | B |
| Example 68 | M-26(0.20g) | M-6 (0.70g) | 0.8 | 1.0 | 1.3 | A | C | B |
| Example 69 | M-26(0.40g) | M-8 (0.50 g) | 0.9 | 1.0 | 1.1 | A | B | B |
| Example 70 | M-34 (0.40g) | M-6 (0.50 g) | 1.0 | 1.0 | 1.1 | A | B | B |

(continued)

| | Ethylenically Unsaturated Compound (ii) | Other Ethylenically Unsaturated Compound | Developing Property | Sensitivity | Printing Durability | Ink-Receptive Property | Processing Property | Reproducibility of Halftone Dot |
|---|---|---|---|---|---|---|---|---|
| Example 71 | M-28 (0.40g) | M-6 (0.50 g) | 1.0 | 1.0 | 1.1 | A | B | B |
| Comparative Example 7 | None | M-5 (0.90 g) | 1.0 | 1.0 | 1.0 | A | D | c |
| Comparative Example 8 | None | M-6 (0.90 g) | 0.9 | 1.1 | 1.1 | A | D | C |

As shown in Table 3, it can also be seen in the combination of Photosensitive layer 3 with Developer 1 that the processing property is dramatically improved by using the ethylenically unsaturated compound (ii) having a hydrophilic group according to the invention. Similar to the results shown in Table 1, it can be seen that not only the printing durability but also the reproducibility of halftone dot are further improved in case of using the ethylenically unsaturated compound having a hydrophilic group and a photo-oxidizable group. Further, the similar result is observed when the ethylenically unsaturated compound having a photo-oxidizable group is separately added.

## Claims

1. A method of preparing a lithographic printing plate comprising:

   (A) an exposure step of exposing imagewise a lithographic printing plate precursor comprising, in the following order, a hydrophilic support, a photosensitive layer containing (i) a binder polymer, (ii) an ethylenically unsaturated compound having a hydrophilic group selected from the group consisting of at least one of an acid group and a salt thereof, an onium salt and a polyalkyleneoxy group and (iii) a polymerization initiator and a protective layer; and
   (B) a development step of removing an unexposed area of the photosensitive layer and the protective layer of the lithographic printing plate precursor with a one bath with a developer having pH of from 2 to 11.

2. The method of preparing a lithographic printing plate as claimed in Claim 1, wherein a log P value of the ethylenically unsaturated compound (ii) is from -1.00 to 3.50.

3. The method of preparing a lithographic printing plate as claimed in Claim 1 or 2, wherein the ethylenically unsaturated compound (ii) is a compound having a group represented by one of the following formulae:

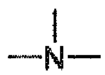 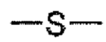

4. The method of preparing a lithographic printing plate as claimed in any one of Claims 1 to 3, wherein the ethylenically unsaturated compound (ii) is a compound having a group represented by one of the following formulae:

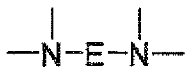 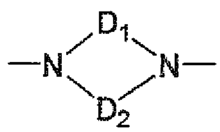 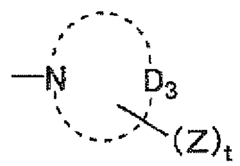

wherein E represents (a) a divalent saturated hydrocarbon group, (b) an alicyclic group which may contain up to two atoms selected from the group consisting of a nitrogen atom, an oxygen atom and a sulfur atom in ring-forming atoms, (c) an arylene group or (d) a heterocyclic aromatic group, $D_1$ and $D_2$ each independently represents a saturated hydrocarbon group, $D_3$ represents a group which forms the ring together with the nitrogen atom and is composed of atoms selected from the group consisting of a carbon atom, an oxygen atom, a hydrogen atom, a nitrogen atom and a sulfur atom, t represents an integer from 1 to 10, and Z represents a hydrogen atom, a saturated hydrocarbon group or a group represented by the following formula:

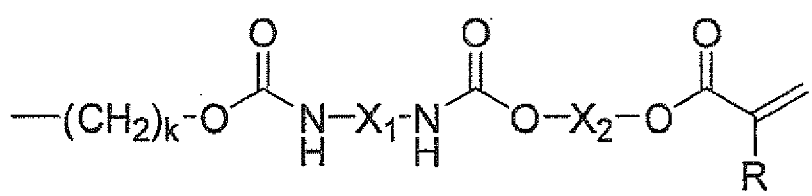

wherein $X_1$ represents a saturated hydrocarbon group or an aromatic hydrocarbon group, $X_2$ represents a saturated hydrocarbon group, an aromatic hydrocarbon group or a group represented by $-CH_2(O\text{-}Alk)_n-$, Alk represents an alkylene group, n represents an integer from 1 to 50, R represents a hydrogen atom or a methyl group, and k represents an integer from 1 to 10.

**5.** The method of preparing a lithographic printing plate as claimed in any one of Claims 1 to 4, wherein the ethylenically unsaturated compound (ii) has at least one group selected from the group consisting of a urethane group, a urea group and a thiourethane group.

**6.** The method of preparing a lithographic printing plate as claimed in any one of Claims 1 to 5, wherein the ethylenically unsaturated compound (ii) is an oligomer having a weight average molecular weight from 1,000 to 10,000.

**7.** The method of preparing a lithographic printing plate as claimed in Claim 1, wherein the ethylenically unsaturated compound (ii) is a compound represented by the following formula (I):

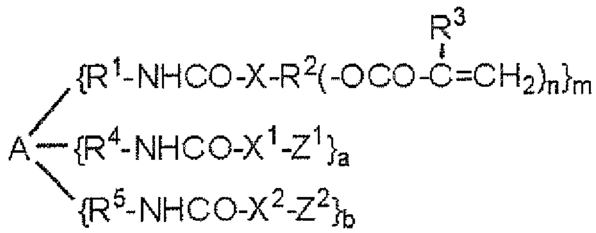

(I)

wherein, A represents the following group a) or b):

a) a 2- to 6-valent hydrocarbon residue which may contain one or more ether bonds, ester bonds and amido bonds;
b) a 2- or 3-valent urea residue;

X, $X^1$ and $X^2$ each independently represents -0- or -NR-, R represents an alkyl group, $R^1$, $R^4$ and $R^5$ each independently represents a divalent hydrocarbon residue, $R^2$ represents a 2- to 6-divalent straight chain or branched hydrocarbon residue, $R^3$ represents a hydrogen atom or a methyl group, $Z^1$ represents a hydrophilic group selected from the group consisting of at least one of an acid group and a salt thereof, an onium salt and a polyakyleneoxy group, $Z^2$ represents a hydrophobic group selected from the group consisting of an alkyl group, a cycloallcyl group, an arylalkyl group, an alkylaryl group, an aryl group, an alkoxy group, a fluoroalkyl group or a perfluoroalkyl group and a silicone group, n, m and a each independently represents an integer from 1 to 5, and b represents an integer from 0 to 5, provided that $2 \leq (m+a+b) \leq 6$ and $1 \leqq (a+b) \leq 5$.

**8.** The method of preparing a lithographic printing plate as claimed in Claim 1 or 2, wherein the photosensitive layer further contains (ii') an ethylenically unsaturated compound having at least one group selected from the group consisting of groups represented by the following formulae:

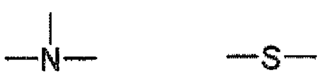

**9.** The method of preparing a lithographic printing plate as claimed in Claim 1 or 2, wherein the photosensitive layer further contains (ii') an ethylenically unsaturated compound having at least one group selected from the group consisting of groups represented by the following formulae:

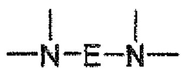
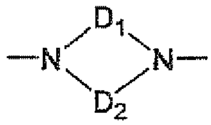
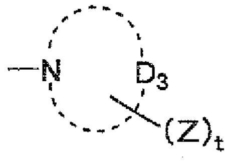

wherein, E represents (a) a divalent saturated hydrocarbon group, (b) an alicyclic group which may contain up to two atoms selected from the group consisting of a nitrogen atom, an oxygen atom and a sulfur atom in ring-forming atoms, (c) an arylene group or (d) a heterocyclic aromatic group, $D_1$ and $D_2$ each independently represents a saturated hydrocarbon group, $D_3$ represents a group which forms the ring together with the nitrogen atom and is composed of atoms selected from the group consisting of a carbon atom, an oxygen atom, a hydrogen atom, a nitrogen atom and a sulfur atom, t represents an integer from 1 to 10, and Z represents a hydrogen atom, a saturated hydrocarbon group or a group represented by the following formula:

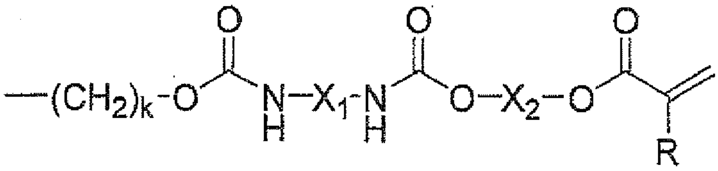

wherein, $X_1$ represents a saturated hydrocarbon group or an aromatic hydrocarbon group, $X_2$ represents a saturated hydrocarbon group, an aromatic hydrocarbon group or a group represented by $-CH_2(O\text{-}Alk)_n-$, Alk represents an alkylene group, n represents an integer from I to 50, R represents a hydrogen atom or a methyl group, and k represents an integer from 1 to 10.

**10.** The method of preparing a lithographic printing plate as claimed in Claim 8, wherein the ethylenically unsaturated compound (ii') is the following compound M-1 or M-2:

M-1 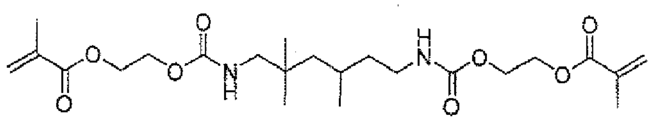

M-2 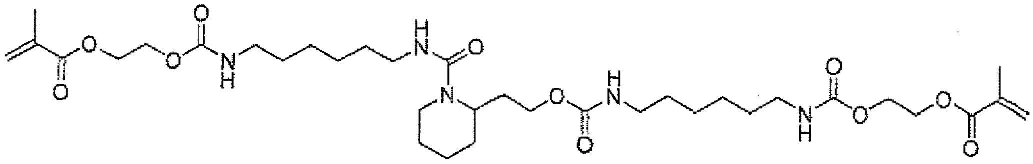

**11.** The method of preparing a lithographic printing plate as claimed in any one of Claims 1 to 10, wherein the binder polymer (i) is polyvinyl butyral.

**12.** The method of preparing a lithographic printing plate as claimed in any one of Claims 1 to 10, wherein the binder polymer (i) is a mixture of polyvinyl butyral and a (meth)acrylic polymer.

**13.** The method of preparing a lithographic printing plate as claimed in any one of Claims 1 to 12, wherein the developer contains a water-soluble amine compound and an ion of the amine compound.

**14.** The method of preparing a lithographic printing plate as claimed in Claim 13, wherein the water-soluble amine compound is at least one organic amine compound selected from the group consisting of monoethanolamine,

diethanolamine, triethanolamine, N-hydroxyethylmorpholine and 4-dimethylammopyridine.

**15.** The method of preparing a lithographic printing plate as claimed in any one of Claims 1 to 14, wherein the developer contains an organic solvent in an amount from 0.001 to 2.0% by weight.

**16.** The method of preparing a lithographic printing plate as claimed in Claim 15, wherein the organic solvent is an organic solvent selected from the group consisting of an alcohol having from 6 to 20 carbon atoms.

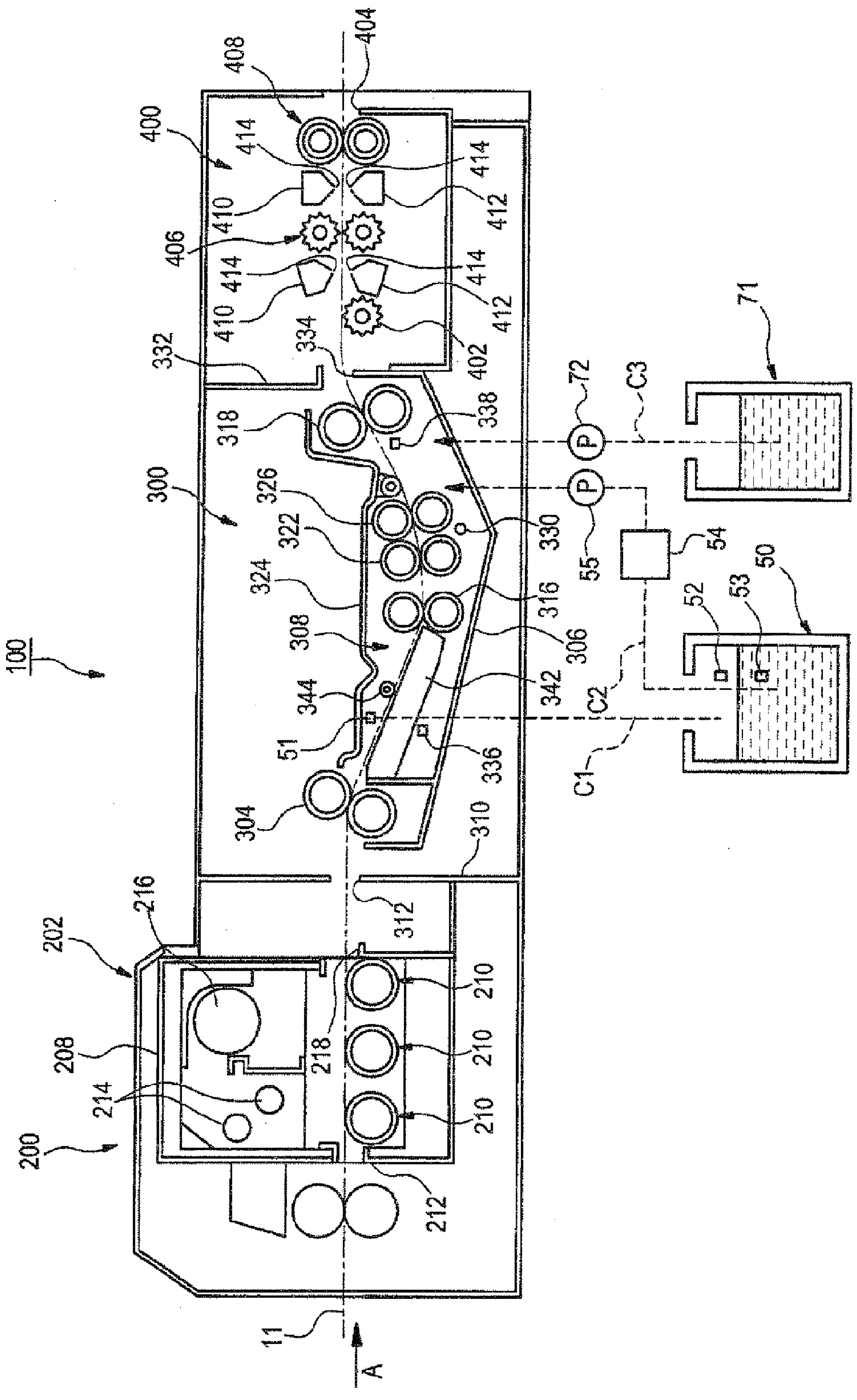
100
200
202
208
210
212
214
216
218
300
304
306
308
310
312
316
318
322
324
326
330
332
334
336
338
342
344
400
402
404
406
408
410
412
414
11
A
51
52
53
54
55
50
71
72
C1
C2
C3
P

FIG. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11065126 A
- EP 1868036 A
- JP 2007538279 T
- JP 2007206217 A
- JP 10282679 A
- JP 2304441 A
- JP 2005238816 A
- JP 2005125749 A
- JP 2006239867 A
- JP 2006215263 A
- JP 5045885 A
- JP 6035174 A
- JP 2007187836 A
- JP 2008276155 A
- JP 2005250438 A
- JP 2005250158 A
- JP 2001075279 A
- WO 2007057442 A
- JP 46027926 B
- JP 51047334 B
- JP 57196231 A
- JP 59005240 A
- JP 59005241 A
- JP 2226149 A
- JP 1165613 A
- JP 54021726 B
- JP 48064183 A
- JP 49043191 B
- JP 52030490 B
- JP 46043946 B
- JP 1040337 B
- JP 1040336 B
- JP 2025433 A
- JP 61022048 A
- JP 4537377 B
- JP 4486516 B
- JP 2007058170 A
- JP 2007093866 A
- JP 2007072816 A
- JP 2006189604 A
- JP 2007171406 A
- JP 2007206216 A
- JP 2007225701 A
- JP 2007225702 A
- JP 2007316582 A
- JP 2007328243 A
- EP 1349006 A
- WO 2005029187 A
- JP 2001133969 A
- JP 2002023360 A
- JP 2002040638 A
- JP 2002278057 A
- JP 2007090850 A
- JP 5005005 A
- JP 2001222101 A
- JP 2008195018 A
- JP 2005509192 T
- JP 2004310000 A
- JP 2005250216 A
- JP 2006259137 A
- JP 2005119273 A
- JP 2008203359 A
- JP 2008276166 A
- JP 2009047927 A


### Non-patent literature cited in the description


- *Nippon Secchaku Kyokaishi,* 1984, vol. 20 (7), 300-308
- Senryo Binran. The Society of Synthetic Organic Chemistry, 1970
- Kobunshi Jiten. 2005, 683-684